# EUROPÄISCHE PATENTANMELDUNG

(11) **EP 4 274 066 A1**
(43) Veröffentlichungstag der Anmeldung: **08.11.2023**
(21) Anmeldenummer: 23170372.9
(22) Anmeldetag: 27.04.2023
(51) Int. Cl.: H02K 5/10, H02K 5/22, H02K 15/00

(54) **FAHRZEUGAGGREGAT MIT DRUCKAUSGLEICHSELEMENT**

(30) Priorität: 02.05.2022 DE 102022110763
(71) Anmelder: Schwäbische Hüttenwerke Automotive GmbH, 73433 Aalen (DE)
(72) Erfinder: Meinig, Uwe, 88348 Bad Saulgau (DE)
(74) Vertreter: SSM Sandmair

(57) **Zusammenfassung**

Fahrzeugaggregat umfassend:
- ein Gehäuse mit einer Gehäusehüllstruktur (5), die eine Gehäuseöffnung (8) aufweist,
- ein im Gehäuse (1) aufgenommenes Elektrobauteil (16),
- einen elektrischen Verbinder (10) mit einem äußeren Verbinderkontakt für den elektrischen Anschluss an ein elektrisches System eines Fahrzeugs und einem inneren Verbinderkontakt (14),
- einen mit dem Elektrobauteil (16) elektrisch leitend verbundenen Bauteilkontakt (9), der in einem Konnektierungsbereich (A) mit dem inneren Verbinderkontakt (14) verbunden ist,
- einen Verschlusskörper (20) zum Verschließen der Gehäuseöffnung (8) gegen Flüssigkeitseintritt und
- ein gasdurchlässiges Druckausgleichselement (15), das Bestandteil des Verschlusskörpers (20) ist, um über den Verschlusskörper (20) einen Druckausgleich mit der Umgebung des Gehäuses zu ermöglichen,
- wobei die Gehäuseöffnung (8) im nicht verschlossenen Zustand einen Zugriff auf den Konnektierungsbereich (A) ermöglicht.

## Beschreibung

Die Erfindung betrifft ein Fahrzeugaggregat, wie etwa eine elektrisch angetriebene Pumpe, und ein Verfahren zur Montage des Fahrzeugaggregats, wobei das Fahrzeugaggregat ein Gehäuse mit einer Gehäuseöffnung aufweist, die mittels eines gasdurchlässigen Druckausgleichselements zumindest im Wesentlichen flüssigkeitsdicht verschlossen ist. Spezieller betrifft die Erfindung die Anordnung der Gehäuseöffnung relativ zu einem Konnektierungsbereich für ein Elektrobauteil des Fahrzeugaggregats.

Aufgrund Temperaturschwankungen und Schwankungen des Umgebungsdrucks, wie sie etwa bei Berg- und Talfahrt auftreten, besteht bei den in Kraftfahrzeugen eingesetzten elektrischen und/oder elektronischen Bauteilen, einschließlich elektromechanischen Bauteilen, die Gefahr, dass Wasser und Schmutz in die Gehäuse dieser Elektrobauteile gelangen und Störungen beziehungsweise Defekte verursachen. Aus diesem Grund werden bei Fahrzeugaggregaten mit Elektrobauteilen vielfach Druckausgleichselemente, zumeist in Form von Druckausgleichsmembranen, eingesetzt, die einen Ausgleich von Druckunterschieden zwischen dem Gehäuseinnenraum und der äußeren Umgebung bewirken. Die Druckausgleichselemente ermöglichen einerseits einen Druckausgleich, verhindern andererseits jedoch, dass Schmutzpartikel oder flüssige Medien, wie etwa Wasser oder Öl, in das Gehäuseinnere eindringen. Als Druckausgleichselemente beziehungsweise Filtermedien kommen unter anderem selbstklebende, verschweißte oder anderweitig mechanisch befestigte Druckausgleichselemente aus PTFE, ePTFE oder Nylon-Vlies zum Einsatz. Eine weitgehende Dichtigkeit gegen Flüssigkeitseintritt wird typischerweise durch die Wahl eines hydrophoben und/oder oleophoben Materials als Filterbeziehungsweise Membranmaterial erhalten.

Die DE 10 2004 056 662 A1 und die DE 10 2008 001 594 A1 offenbaren beispielsweise die Anordnung einer Druckausgleichsmembran an einem Gehäusedeckel, der einen Gehäuseinnenraum abdeckelt, in dem Elektrobauteile des jeweiligen Fahrzeugaggregats aufgenommen sind. Da das Druckausgleichselement an einer großen Struktur, dem Gehäusedeckel, direkt befestigt ist, muss im Falle einer fehlerhaften Montage des Druckausgleichselements der gesamte Gehäusedeckel und somit ein großes, komplexes und dementsprechend teures Bauteil als defekt ausgesondert werden. Ferner wird die übliche Dichtheitsprüfung des Gehäuses in der Serienproduktion erschwert, da beim Andocken der Über- und/oder Unterdruckquelle zur Bestimmung der Leckraten das Druckausgleichselement einen für kurze Prüfzeiten erforderlichen schnellen Druckausgleich zwischen der angedockten Druckquelle und dem Innenraum des Gehäuses erschwert. Weist der Gehäusedeckel einen elektrischen Verbinder für den elektrischen Anschluss des Fahrzeugaggregats an ein elektrisches System des Fahrzeugs auf, bereitet die elektrische Konnektierung des Elektrobauteils in der Montage ein weiteres Problem. Das Elektrobauteil muss entweder vor der Montage des Gehäusedeckels oder automatisch mit der Montage des Gehäusedeckels mit dem elektrischen Verbinder elektrisch verbunden werden. Eine in Bezug auf die Montage günstige Lösung ist die Konnektierung mittels einer Press-Fit Verbindung. Press-Fit Verbindungen können sich andererseits hinsichtlich der Qualität der elektrischen Konnektierung als problematisch erweisen.

Es ist eine Aufgabe der Erfindung, bei einem Fahrzeugaggregat, das ein Gehäuse mit einem Druckausgleichselement und ein im Gehäuse aufgenommenes Elektrobauteil umfasst, eine einfache und zuverlässige elektrische Konnektierung des Elektrobauteils zu ermöglichen.

Eine weitere Aufgabe kann darin bestehen, die Prüfung der Dichtheit des Gehäuses zu vereinfachen, insbesondere die hierfür erforderliche Prüfzeit zu verkürzen.

Die Erfindung geht von einem Fahrzeugaggregat aus, das ein Gehäuse und ein im Gehäuse aufgenommenes elektrisches und/oder elektronisches und/oder elektromechanisches Bauteil, wie etwa einen Elektromotor und/oder eine elektronische Steuerung und/oder einen oder mehrere Sensoren, umfasst. Bauteile dieser Art sowie Teile davon werden im Folgenden als "Elektrobauteil" bezeichnet. Das Fahrzeugaggregat weist ferner einen elektrischen Verbinder mit einem äußeren Verbinderkontakt für den elektrischen Anschluss des Fahrzeugaggregats an ein elektrisches System eines Fahrzeugs und einem inneren Verbinderkontakt auf. Das Elektrobauteil ist elektrisch leitend mit einem Bauteilkontakt verbunden, der in einem Konnektierungsbereich mit dem inneren Verbinderkontakt des elektrischen Verbinders elektrisch leitend gefügt, beispielsweise gelötet, geschweißt und/oder geklemmt ist.

Das Gehäuse umfasst eine Gehäusehüllstruktur, die einen Innenraum des Gehäuses am Umfang und/oder an einer Stirnseite begrenzt und mit einer Gehäuseöffnung versehen ist. Die Gehäusehüllstruktur bildet mit einer oder mehreren anderen Gehäusestrukturen das Gehäuse des Fahrzeugaggregats und kann zur Bildung des Gehäuses als strukturelle Einheit montiert werden. Das Fahrzeugaggregat weist einen Verschlusskörper zum Verschließen der Gehäuseöffnung gegen Flüssigkeitseintritt auf. Der Verschlusskörper umfasst ein gasdurchlässiges Druckausgleichselement, dass zumindest im Wesentlichen flüssigkeitsdicht ist, aber im montierten Zustand des Verschlusskörpers einen Druckausgleich mit der äußeren Umgebung des Gehäuses über die Gehäuseöffnung und den Verschlusskörper ermöglicht. Obgleich das Druckausgleichselement bei entsprechendem Design grundsätzlich den Verschlusskörper im Ganzen bilden kann, wird es demgegenüber bevorzugt, wenn der Verschlusskörper einen gas- und flüssigkeitsdichten Trägerkörper umfasst und das Druckausgleichselement flüssigkeitsdicht, bevorzugt gasdicht, mit dem Trägerkörper gefügt ist, beispielsweise durch Schweißen oder Kleben.

Nach der Erfindung erlaubt die Gehäuseöffnung aufgrund ihrer Position und Größe im nicht verschlossenen Zustand, das heißt vor der Befestigung des Verschlusskörpers, einen Zugriff auf den Konnektierungsbereich mit einem Werkzeug, beispielsweise mit einem Fügewerkzeug oder einem Prüf- und/oder Diagnosewerkzeug, und/oder eine Sichtkontrolle des Konnektierungsbereichs. Die mit der Gehäuseöffnung versehene Gehäusehüllstruktur kann daher bereits vor der Montage des Verschlusskörpers mit der einen oder den mehreren weiteren Hüllstrukturen zu dem Gehäuse des Fahrzeugaggregats gefügt werden, so dass zur Fertigstellung des Gehäuses lediglich noch der Verschlusskörper zum Verschließen der Gehäuseöffnung montiert werden muss.

Der Konnektierungsbereich liegt in ersten Ausführungen in dem von der Gehäusehüllstruktur begrenzten Gehäuseinnenraum und ist vor der Anbringung des Verschlusskörpers über die in diesem Zustand noch offene Gehäuseöffnung einem Werkzeug und/oder einer Sichtkontrolle zugänglich. In zweiten Ausführungen ragen der Bauteilkontakt und der damit zu konnektierende innere Verbinderkontakt in oder durch die Gehäuseöffnung nach außen vor, so dass sich zumindest ein Teil des Konnektierungsbereichs außerhalb des Gehäuseinnenraums befindet. Der Verschlusskörper bildet in den zweiten Ausführungen eine Kappe, die im montierten Zustand die Gehäuseöffnung verschließt und die konnektierten Kontakte über ihre aus der Gehäuseöffnung vorragende Länge schützend umgibt.

Ist das Druckausgleichselement nicht unmittelbar mit der vergleichsweise großen Gehäusehüllstruktur gefügt, die den Gehäuseinnenraum zumindest teilweise umgibt oder zumindest einen überwiegenden Teil des Gehäuseinnenraums abdeckt, sondern Bestandteil eines im Vergleich mit der Gehäusehüllstruktur kleinen Verschlusskörpers, kann die Leckageprüfung in der Serienproduktion einfach und innerhalb kurzer Zeit über die Gehäuseöffnung durchgeführt und die Gehäuseöffnung danach mit dem Verschlusskörper verschlossen werden. Von der noch nicht verschlossenen Gehäuseöffnung abgesehen kann die Dichtheit des Gehäuses überprüft werden. Das Fahrzeugaggregat oder zumindest das Gehäuse kann bereits so weit als möglich fertig montiert sein, so dass eine zuverlässige Leckageprüfung, beispielsweise in Form einer Druckabfallprüfung, mit kurzer Taktzeit möglich ist, ohne dass ein Druckausgleichselement die Leckageprüfung erschwert, verzögert oder gar verfälscht. Aufgrund ihrer Anordnung relativ zum Konnektierungsbereich muss der innere Verbinderkontakt nicht bereits vor dem Zusammenbau des Gehäuses mit dem Bauteilkontakt elektrisch leitend verbunden werden. Es ist auch keine Press-Fit oder Steckverbindung erforderlich, obgleich eine solche Verbindung nicht von vornherein ausgeschlossen werden soll. Aufgrund der verbesserten Zugänglichkeit können der innere Verbinderkontakt und der Bauteilkontakt nach der Montage der Gehäusehüllstruktur zuverlässig elektrisch leitend miteinander verbunden werden. Insbesondere können bewährte Verbindungstechniken, wie Löten oder Schweißen, zum Einsatz kommen.

Der Verschlusskörper kann in der Art eines Deckels gebildet sein und den Konnektierungsbereich abdeckeln. Er kann zumindest im Wesentlichen scheibenförmig sein, um die Gehäuseöffnung nur stirnseitig abzudecken. Er kann aber auch kappen- oder topfförmig sein, um die Gehäuseöffnung abzudecken und zusätzlich optional über die Gehäuseöffnung nach außen vorragende Kontakte über den Umfang zu umgeben. Der Verschlusskörper sitzt im Bereich der Gehäuseöffnung vorteilhafterweise auf der Gehäusehüllstruktur.

Die Gehäuseöffnung kann in oder an einer Umfangswand der Gehäusehüllstruktur vorgesehen sein. Die Gehäuseöffnung kann sich vollständig im Bereich der Umfangswand erstrecken. In einer Modifikation kann sie sich von der Umfangswand ausgehend in eine Stirnwand der Gehäusehüllstruktur erstrecken. Eine Gehäuseöffnung, die sich ganz oder nur teilweise in oder an einer Umfangswand der Gehäusehüllstruktur erstreckt, eignet sich beispielsweise in Ausführungen, in denen der innere Verbinderkontakt von einer Stirnwand der Gehäusehüllstruktur in den Gehäuseinnenraum vorragt. Bevorzugt ist die Gehäuseöffnung jedoch in einer Stirnwand der Gehäusehüllstruktur vorgesehen und wird umlaufend von einer Stirnwandfläche der Gehäusehüllstruktur umgeben.

Vorteilhaft ist, wenn die Gehäuseöffnung deutlich kleiner als die Gehäusehüllstruktur, d.h. deutlich kleiner als die Stirnwandfläche und/oder Umfangswandfläche der Gehäusehüllstruktur ist. Ist die Gehäuseöffnung an einer Stirnseite der Gehäusehüllstruktur vorgesehen, kann die Gehäusehüllstruktur in einer Draufsicht auf die Gehäuseöffnung insgesamt eine Stirnwandfläche aufweisen, die mehr als doppelt oder mehr als dreimal oder mehr als viermal so groß wie die Gehäuseöffnung ist. Ist die Gehäuseöffnung am Umfang der Gehäusehüllstruktur vorgesehen, kann die Gehäusehüllstruktur in einer Draufsicht auf die Gehäuseöffnung, d.h. in einer Seitenansicht der Gehäusehüllstruktur, eine parallel zur Richtung der Sicht projizierte Umfangswandfläche aufweisen, die mehr als doppelt oder mehr als dreimal oder mehr als viermal so groß wie die Gehäuseöffnung ist.

In bevorzugten Ausführungen liegen die Gehäuseöffnung und der Konnektierungsbereich in einer Flucht. Im Sinne der Erfindung liegen die Gehäuseöffnung und der Konnektierungsbereich dann in einer Flucht, wenn eine gerade Linie vom Konnektierungsbereich ausgehend durch die Gehäuseöffnung gezogen werden kann. Liegen die Gehäuseöffnung und der Konnektierungsbereich in diesem Sinne in einer gemeinsamen Flucht, kann der Konnektierungsbereich mit einem Werkzeug auf geradem Wege erreicht werden, wobei das Werkzeug gegebenenfalls in Bezug auf die Gehäuseöffnung schräg gehalten werden muss. Ebenso ist eine Sichtkontrolle des Konnektierungsbereichs durch die Gehäuseöffnung möglich. Bei dem Werkzeug kann es sich beispielsweise um ein Prüfwerkzeug oder insbesondere um ein Fügewerkzeug handeln. In bevorzugten Ausführungen kann ein Fügewerkzeug durch die noch nicht verschlossene Gehäuseöffnung in den von der Gehäusehüllstruktur begrenzten Gehäuseinnenraum bis zum Kontaktbereich geführt und der interne Verbinderkontakt und der Bauteilkontakt elektrisch leitend gefügt werden.

Besonders günstig ist es, wenn die Gehäuseöffnung in Draufsicht mit einem flächenmäßig zumindest überwiegenden Teil des Konnektierungsbereichs überlappt. Die Gehäuseöffnung und der zumindest überwiegende Flächenbereich des Konnektierungsbereichs liegen in derartigen Ausführungen in einer zur Gehäuseöffnung orthogonalen Flucht. Die orthogonale Flucht erstreckt sich durch die Gehäuseöffnung und den Konnektierungsbereich und kann sich parallel insbesondere zu einer Normalen eines Querschnitts der Gehäuseöffnung erstrecken. Variiert der Querschnitt der Gehäuseöffnung von außen nach innen, kann sich die orthogonale Flucht insbesondere parallel zur Normalen eines kleinsten Querschnitts erstrecken. Befindet sich der Konnektierungsbereich im Innenraum des Gehäuses, ist es vorteilhaft, wenn zumindest der flächenmäßig überwiegende Teil des Konnektierungsbereichs in orthogonaler Draufsicht auf die Gehäuseöffnung durch diese hindurch sichtbar ist. Ein im Gehäuseinnenraum befindlicher Konnektierungsbereich des inneren Verbinderkontakts und des Bauteilkontakts ist dann sichtbar, wenn wenigstens einer dieser beiden Kontakte durch die Gehäuseöffnung hindurch sichtbar ist.

Erstreckt sich im Falle einer fluchtenden Anordnung die Flucht von Gehäuseöffnung und Konnektierungsbereich nicht orthogonal auf die Gehäuseöffnung, sondern mit einer Neigung schräg zu einer orthogonal zu einem Querschnitt der Gehäuseöffnung weisenden Flucht, wird es bevorzugt, wenn die Flucht von Gehäuseöffnung und Konnektierungsbereich mit einem Neigungswinkel von höchstens 50° oder höchstens 40° zur orthogonalen Flucht weist.

Das Fahrzeugaggregat kann mehrere mit dem Elektrobauteil oder einem im Gehäuse optional aufgenommenen weiteren Elektrobauteil elektrisch leitend verbundene Bauteilkontakte aufweisen. Entsprechend kann der Verbinder mehrere elektrisch leitende äußere Verbinderkontakte jeweils für den Anschluss an das elektrische System des Fahrzeugs und mehrere elektrisch leitende innere Verbinderkontakte aufweisen, die im Konnektierungsbereich jeweils mit einem der Bauteilkontakte elektrisch leitend gefügt sind. Die Gehäuseöffnung ist vorteilhafterweise nach Größe und Anordnung so gestaltet, dass sie im nicht verschlossenen Zustand einen Zugriff auf mehrere und vorzugsweise alle Paare der inneren Verbinderkontakte und Bauteilkontakte ermöglicht.

Sind der eine oder die mehreren weiteren Verbinderkontakte und Bauteilkontakte im Gehäuseinnenraum angeordnet, ist der Zugriff durch die noch offene Gehäuseöffnung möglich. Der jeweilige Bauteilkontakt und der jeweilige innere Verbinderkontakt sind im nicht verschlossenen Zustand der Gehäuseöffnung daher mittels eines die Gehäuseöffnung durchgreifenden Fügewerkzeugs elektrisch leitend fügbar, und/oder es kann die elektrische Verbindung zwischen dem jeweiligen Bauteilkontakt und inneren Verbinderkontakt mittels eines Prüfwerkzeugs oder mit dem Auge geprüft werden. In solchen ersten Ausführungen wird es bevorzugt, wenn alle Bauteilkontakte und/oder alle inneren Verbinderkontakte im nicht verschlossenen Zustand der Gehäuseöffnung in Draufsicht auf die Gehäuseöffnung sichtbar sind.

In den alternativen zweiten Ausführungsformen ragen die Bauteilkontakte und zugehörigen inneren Verbinderkontakte in oder durch die Gehäuseöffnung und sind dementsprechend besonders leicht zugänglich. Zweckmäßigerweise gilt dies für alle Bauteilkontakte, des Fahrzeugaggregats, soweit diese Bauteilkontakte über den elektrischen Verbinder an das elektrische System des Fahrzeugs anschließbar sind.

Denkbar sind auch Mischformen, in denen wenigstens einer der Bauteilkontakte und wenigstens einer der inneren Verbinderkontakte im Gehäuseinnenraum und wenigstens ein anderer der Bauteilkontakte und wenigstens ein anderer der inneren Verbinderkontakte außen vor der Gehäuseöffnung oder in der Gehäuseöffnung konnektiert werden. Eine derartige Aufteilung des Konnektierungsbereichs kann allerdings zu einer Beeinträchtigung der Zugänglichkeit zu dem im Gehäuseinnenraum gelegenen Teil des Konnektierungsbereichs führen.

Für den einen oder die mehreren weiteren Bauteilkontakte und inneren Verbinderkontakte gilt in Bezug auf die fluchtende Anordnung jeweils das für nur ein Kontaktpaar Gesagte in gleicher Weise.

Das Gehäuse kann eine ein- oder mehrteilige Gehäuseträgerstruktur, die das Elektrobauteil lagert, und einen mit der Gehäuseträgerstruktur gefügten Gehäusedeckel umfassen. Die Gehäuseträgerstruktur und der Gehäusedeckel können gemeinsam den genannten Gehäuseinnenraum umgeben. In diesem Gehäuseinnenraum kann das Elektrobauteil aufgenommen sein. Im Gehäuseinnenraum kann stattdessen oder zusätzlich der Konnektierungsbereich gebildet sein. Der Gehäusedeckel kann die Gehäusehüllstruktur sein, die erfindungsgemäß mit der dem Druckausgleich dienenden und den Zugang ermöglichenden Gehäuseöffnung versehen ist.

In einer Weiterbildung umfasst das Fahrzeugaggregat einen Elektromotor und eine elektronische Steuerung für den Elektromotor. Das Elektrobauteil kann den Elektromotor oder die elektronische Steuerung oder einen Teil der elektronischen Steuerung bilden. Das Gehäuse kann in derartigen Ausführungen ein Motorgehäuse mit einem Motorraum für den Elektromotor, einen Motorraumdeckel und einen Elektronikraumdeckel umfassen. Das Elektrobauteil und/oder der Konnektierungsbereich ist oder sind in einem Elektronikraum aufgenommen, der den vorstehend erläuterten Gehäuseinnenraum bildet. Der Motorraumdeckel trennt den Motorraum an einer Stirnseite vom Elektronikraum. Der Elektronikraumdeckel begrenzt den Elektronikraum an der vom Motorraumdeckel abgewandten Stirnseite und bildet die mit der Gehäuseöffnung versehene Gehäusehüllstruktur. Vorzugsweise verschließt der Elektronikraumdeckel den Elektronikraum flüssigkeitsdicht und vom erforderlichen Druckausgleich über das Druckausgleichselement abgesehen auch weitestgehend gasdicht. Der Elektronikraumdeckel kann mit dem Motorgehäuse oder vorzugsweise unmittelbar nur mit dem Motorraumdeckel gefügt sein.

Der Verbinder kann ein Verbindergehäuse und eine elektrische Verbindungsleitung umfassen, die sich durch das Verbindergehäuse erstreckt und den äußeren Verbinderkontakt und den inneren Verbinderkontakt bildet. Das Verbindergehäuse und die Gehäusehüllstruktur können eine strukturelle Einheit bilden, insbesondere als Einheit an einer oder mehreren anderen Gehäusestrukturen des Gehäuses montiert sein. Dabei kann das Verbindergehäuse von der Gehäusehüllstruktur in eine Richtung normal zu einer Stirnseite der Gehäusehüllstruktur oder vorzugsweise in eine radiale und/oder tangentiale Richtung vorragen. Das Verbindergehäuse kann mit der Gehäusehüllstruktur in einem Stück geformt sein, beispielsweise in einem Gießverfahren. Zweckmäßigerweise sind die Gehäusehüllstruktur und das Verbindergehäuse separat geformt und miteinander zu einer Montageeinheit gefügt.

Der äußere Verbinderkontakt kann ein äußeres Ende der Verbindungsleitung bilden. Die Verbindungsleitung kann sich über den inneren Verbinderkontakt hinaus weiter in den Gehäuseinnenraum erstrecken. Bevorzugt bildet der innere Verbinderkontakt aber ein Ende der elektrischen Verbindungsleitung. Das Verbindergehäuse kann die Verbindungsleitung halten und relativ zum Bauteilkontakt positionieren, so dass der innere Verbinderkontakt dem Bauteilkontakt in einem geringen Abstand gegenüberliegt oder am Bauteilkontakt bereits mit Kontakt anliegt. Vorteilhafterweise hält das Verbindergehäuse die Verbindungsleitung so, dass durch die Montage der Gehäusehüllstruktur zugleich auch der innere Verbinderkontakt relativ zum Bauteilkontakt unmittelbar in einer Fügeposition für das Konnektieren positioniert ist und vor dem Fügen der Kontakte kein weiterer Montageschritt erforderlich ist. Das Verbindergehäuse kann die Verbindungsleitung vorteilhafterweise so positionieren, dass der innere Verbinderkontakt und die Gehäuseöffnung in einer Flucht sind, die vorzugsweise normal zur Gehäuseöffnung weist, grundsätzlich aber auch schräg zur Gehäuseöffnung weisen kann.

Der elektrische Verbinder ist vorzugsweise ein Steckverbinder, wobei der äußere Verbinderkontakt ein weibliches oder ein männliches Steckkontaktelement sein kann.

In bevorzugten Ausführungen weist der elektrische Verbinder an einer freien Stirnseite einen Verbinderanschluss für den Anschluss an das elektrische System eines Fahrzeugs auf. Die Verbindungsleitung erstreckt sich bis zu dieser freien Stirnseite und endet dort mit dem äußeren Verbinderkontakt, der Bestandteil des Verbinderanschlusses ist. Die Gehäusehüllstruktur kann die Gehäuseöffnung in einer zum Verbinderanschluss normal bzw. orthogonal weisenden Flucht aufweisen. Ist der Verbinder ein Steckverbinder, befindet sich die Gehäuseöffnung in derartigen Ausführungen vom Verbinderanschluss aus gesehen in Steckrichtung in Verlängerung zum Verbinder.

Ist das Fahrzeugaggregat an einer Stirnseite des elektrischen Verbinders an das elektrische System des Fahrzeugs anschließbar, wird es bevorzugt, wenn eine bezüglich des Verbinders zentrale, orthogonal zur Stirnseite des Verbinders erstreckte Achse die Gehäuseöffnung in Draufsicht auf die Gehäuseöffnung schneidet und die Gehäuseöffnung dem Verbinder nahe in der Draufsicht auf die Gehäuseöffnung in einer Hälfte der Gehäusehüllstruktur angeordnet ist, in die der innere Verbinderkontakt vorragt. Bevorzugt erstreckt sich die Gehäuseöffnung vollständig in dieser Hälfte der Gehäusehüllstruktur. Je näher die Gehäuseöffnung dem Verbinder ist, desto kürzer kann die Länge sein, über die der innere Verbinderkontakt in den Gehäuseinnenraum vorragt. Dies kommt der Positionierung des inneren Verbinderkontakts und auch der Konnektierung von Bauteilkontakt und Verbinderkontakt zugute.

Im Hinblick auf die geforderte Dichtheit des Gehäuses und auch der einfachen Anbringung des Verschlusskörpers wegen ist es vorteilhaft, wenn die Gehäuseöffnung im Vergleich zur Gehäusehüllstruktur klein ist. Da andererseits der Konnektierungsbereich gut zugänglich sein soll, kann die Gehäuseöffnung dem Verbinder direkt benachbart sein.

In typischen Ausführungen umfasst der Verbinder mehrere elektrische Verbindungsleitungen, die sich jeweils durch das Verbindergehäuse erstrecken und jeweils einen äußeren Verbinderkontakt und einen inneren Verbinderkontakt bilden. Das für die eine Verbindungsleitung und die Verbinderkontakte dieser Verbindungsleitung Gesagte gilt auch für jede weitere der Verbindungsleitungen des elektrischen Verbinders.

Der Verschlusskörper umfasst in vorteilhaften Ausführungen einen Durchgang und eine Dichtungsstruktur, die den Durchgang in einer Draufsicht auf den Durchgang umgibt. Das Druckausgleichselement verschließt den Durchgang flüssigkeitsdicht. Das Druckausgleichselement kann insbesondere an einer dem Konnektierungsbereich zugewandten Innenseite des Verschlusskörpers angeordnet sein. Die Dichtungsstruktur ist dazu eingerichtet, die Gehäuseöffnung umlaufend flüssigkeitsdicht, vorzugsweise gasdicht, zu verschließen, entweder im Zusammenwirken direkt mit der Gehäusehüllstruktur oder mittels eines zusätzlichen Dichtungselements.

Der Durchgang weist vorteilhafterweise einen Querschnitt auf, der deutlich kleiner als die Gehäuseöffnung ist. So kann die Gehäuseöffnung mehr als doppelt oder mehr als dreimal oder mehr als viermal so groß wie der Querschnitt des Durchgangs sein. Variiert der Querschnitt des Durchgangs in Durchströmungsrichtung, gilt dies für den kleinsten Querschnitt.

Der Verschlusskörper kann in Bezug auf die Einströmrichtung in den Gehäuseinnenraum stromauf des Druckausgleichselements in oder noch vor dem Durchgang einen Prallschutz gegen zuströmende Partikel umfassen.

Die Dichtungsstruktur kann in ersten Varianten des Verschlusskörpers zugleich eine Fügestruktur bilden, indem der Verschlusskörper längs der Dichtungsstruktur mit der Gehäusehüllstruktur flüssigkeitsdicht und weitestgehend auch gasdicht gefügt wird, wobei die Dichtungsstruktur in Draufsicht auf den Durchgang des Verschlusskörpers vorteilhafterweise auch die Gehäuseöffnung umgibt. Grundsätzlich kann sie stattdessen oder zusätzlich aber auch in der Gehäuseöffnung mit der Gehäusehüllstruktur gefügt werden.

Der Verschlusskörper kann längs einer Fügefläche oder -linie um die Gehäuseöffnung und/oder in der Gehäuseöffnung umlaufend mit der Gehäusehüllstruktur flüssigkeitsdicht, vorzugsweise gasdicht, stoffschlüssig gefügt sein. Dies gilt insbesondere für die ersten Varianten des Verschlusskörpers. Bevorzugt wird der Verschlusskörper mit der Gehäusehüllstruktur durch Schweißen, beispielsweise Ultraschallschweißen oder Laserschweißen oder Reibschweißen, gefügt. Um ein Reibschweißen zu erleichtern, kann die Dichtungsstruktur, falls sie zugleich als Fügestruktur dient, in Bezug auf eine normal bzw. orthogonal zur Gehäuseöffnung weisende Achse rotationssymmetrisch sein.

Der Verschlusskörper kann einen Trägerkörper umfassen, durch den sich der Durchgang erstreckt und mit dem das Druckausgleichselement um den Durchgang zumindest flüssigkeitsdicht und vorzugsweise gasdicht gefügt ist, beispielsweise durch Schweißen, Kleben, Klemmen und/oder Pressen. Die Dichtungsstruktur und/oder der Prallschutz, falls vorhanden, kann öder können am Trägerkörper geformt sein. Vorzugsweise ist der Trägerkörper in einem Verfahren der Urformung in einem Stück geformt, beispielsweise aus Kunststoff, bevorzugt thermoplastischem Kunststoff.

Der Verschlusskörper kann in den ersten Varianten allein aus dem Trägerkörper und dem damit gefügten Druckausgleichselement bestehen. In zweiten Varianten kann der Verschlusskörper zusätzlich eine am Trägerkörper im Bereich der Dichtungsstruktur angeordnete Dichtung, wie etwa ein mittels der Dichtungsstruktur lösbar gehaltenes Dichtungselement, umfassen. Eine Fügestruktur ist in den zweiten Varianten zusätzlich zur Dichtungsstruktur vorgesehen. Sie kann am Trägerkörper geformt sein, beispielsweise in Form eines in Draufsicht umlaufenden Fügeflansches oder mehrerer jeweils flügelförmig vorragender Fügeflansche. Die Fügestruktur kann für eine Befestigung des Verschlusskörpers beispielsweise durch eine Schraub- oder Rastverbindung eingerichtet sein.

Für eine Leckageprüfung kann die Gehäusehüllstruktur in Draufsicht auf die Gehäuseöffnung um diese umlaufend eine freie Gehäuse-Andockfläche für einen umlaufend gasdichten Kontakt mit einer Prüfsonde zur Prüfung der Dichtheit des Gehäuses aufweisen. Im Rahmen dieser Prüfung kann eine Leckrate des Gehäuses bestimmt und beispielsweise mit einer vorgegebenen maximal zulässigen Leckrate verglichen werden. Zur Prüfung wird das Gehäuse mittels der Prüfsonde über die noch nicht verschlossene Gehäuseöffnung mit einem Überdruck oder einem Unterdruck oder nacheinander mit Überdruck und Unterdruck beaufschlagt.

Zur Erleichterung einer Leckageprüfung der Fügeverbindung von Verschlusskörper und Gehäusehüllstruktur können in Draufsicht auf den Verschlusskörper die Gehäusehüllstruktur eine freie Gehäuse-Andockfläche und der Verschlusskörper eine freie Verschlusskörper-Andockfläche jeweils für einen umlaufend gasdichten Kontakt mit der gleichen Prüfsonde aufweisen. Die Verschlusskörper-Andockfläche läuft in der Draufsicht innerhalb der Fügeverbindung um den Durchgang des Verschlusskörpers um. Die Gehäuse-Andockfläche läuft in der gleichen Draufsicht um den Verschlusskörper um, umgibt also auch die Verschlusskörper-Andockfläche. Die vorstehend beschriebene Gehäuse-Andockfläche kann in Zweitfunktion auch die Gehäuse-Andockfläche für die Leckageprüfung der Fügeverbindung bilden.

Die Gehäuse-Andockfläche und die Verschlusskörper-Andockfläche können plane, parallele Stirnflächen sein, die sich vorzugsweise auf gleicher Höhe nebeneinander in einer gemeinsamen Andockebene erstrecken.

Die Gehäusehüllstruktur kann um die Gehäuseöffnung umlaufend einen erhaben vorragenden Andockring mit der Gehäuse-Andockfläche als Stirnfläche aufweisen. Alternativ können die Gehäuseöffnung in einer Vertiefung der Gehäusehüllstruktur angeordnet sein und die Gehäuse-Andockfläche um die Vertiefung umlaufen. Beide Ausführungen ermöglichen die Anordnung der Gehäuse-Andockfläche auf gleicher Höhe mit der optionalen Verschlusskörper-Andockfläche.

Das Fahrzeugaggregat kann insbesondere ein Nebenaggregat, wie etwa ein Verdichter, ein Gebläse oder vorzugsweise eine Pumpe für Kühlmittel, Schmieröl oder Getriebeöl sein. Ein bevorzugtes Beispiel ist eine Pumpe-Motor-Einheit oder Verdichter-Motor-Einheit jeweils mit einem Förderrad zum Fördern von Fluid, einem Elektromotor für einen Drehantrieb des Förderrads und einer elektronischen Steuerung für den Elektromotor, wobei das Förderrad, der Elektromotor und die Steuerung in dem Gehäuse angeordnet sind. Der Elektromotor umfasst einen Stator und einen um eine Drehachse drehbaren Rotor. Das Förderrad ist vorteilhafterweise um die gleiche Drehachse wie der Rotor drehbar und/oder drehunbeweglich mit dem Rotor verbunden.

Die Erfindung betrifft aber nicht nur elektromechanische Fahrzeugaggregate. Auch rein elektrische und/oder elektronische Fahrzeugaggregate, wie etwa eine elektronische Motorsteuerung oder eine Diagnoseeinrichtung, können das erfindungsgemäße Fahrzeugaggregat bilden.

Die Erfindung betrifft nicht nur ein Fahrzeugaggregat, sondern auch ein Verfahren zur Montage eines Fahrzeugaggregats, vorzugsweise des hier offenbarten Fahrzeugaggregats. Hierbei umfasst das Fahrzeugaggregat:
• ein Gehäuse mit einer Gehäusehüllstruktur, die einen Innenraum des Gehäuses am Umfang und/oder an einer Stirnseite begrenzt und eine Gehäuseöffnung aufweist,
• ein im Gehäuse aufgenommenes Elektrobauteil, beispielsweise ein Elektromotor und/oder eine elektronische Steuerung,
• einen elektrischen Verbinder mit einem äußeren Verbinderkontakt für den elektrischen Anschluss des Fahrzeugaggregats an ein elektrisches System eines Fahrzeugs und einem inneren Verbinderkontakt,
• einen mit dem Elektrobauteil elektrisch leitend verbundenen Bauteilkontakt, der in einem Konnektierungsbereich dem inneren Verbinderkontakt benachbart ist,
• einen Verschlusskörper zum Verschließen der Gehäuseöffnung gegen Flüssigkeitseintritt, und
• ein gasdurchlässiges Druckausgleichselement, das Bestandteil des Verschlusskörpers ist, um über den Verschlusskörper einen Druckausgleich mit der Umgebung des Gehäuses zu ermöglichen.

Mit Ausnahme des Verschlusskörpers ist das Fahrzeugaggregat zumindest in diesem Umfang, vorzugsweise in Gänze, bereits zusammengebaut. Die Gehäuseöffnung ist allerdings noch offen. Vor dem Verschließen der Gehäuseöffnung wird der innere Verbinderkontakt mittels eines Fügewerkzeugs elektrisch leitend mit dem Bauteilkontakt gefügt. Der Fügeschritt kann das Fügen und dadurch Konnektieren eines weiteren oder mehrerer weiterer Bauteilkontakte(s) und Verbinderkontakte(s) umfassen. Unmittelbar nach dem Fügeschritt oder optional erst nach einem oder mehreren nachfolgenden anderen Montageschritten wird die Gehäuseöffnung mit dem Verschlusskörper flüssigkeitsdicht, aber über das Druckausgleichselement gasdurchlässig verschlossen.

Ist der Konnektierungsbereich im Innenraum des Gehäuses gebildet, wird das Fügewerkzeug zum Fügen der Kontakte durch die noch offene Gehäuseöffnung zum Konnektierungsbereich geführt, und die zueinander gehörenden Kontakte werden im Gehäuseinnenraum elektrisch leitend gefügt. Ragen die Kontakte durch die Gehäuseöffnung nach außen vor, kann die Konnektierung besonders einfach außen vor der Gehäuseöffnung vorgenommen werden. Die Gehäuseöffnung kann danach mit einem kappenförmigen Verschlusskörper verschlossen werden, der die Kontakte stirnseitig überdeckt und über den Umfang umgibt. Denkbar ist schließlich auch, dass sich die Kontakte bis in die Gehäuseöffnung erstrecken, aber nicht über die Gehäuseöffnung vorragen und nicht im Gehäuseinnenraum, sondern in der Gehäuseöffnung miteinander elektrisch leitend gefügt werden.

In einem dem Fügen der Kontakte vorgelagerten Montageschritt wird die mit der Gehäuseöffnung versehene Gehäusehüllstruktur, die vorzugsweise auch den Verbinder aufweist, mit einer Gehäuseträgerstruktur, die das Elektrobauteil lagert, gefügt, so dass der innere Verbinderkontakt dem Bauteilkontakt im Konnektierungsbereich direkt benachbart ist und im Fügeschritt konnektiert werden kann.

Nachfolgend werden Ausführungsbeispiele der Erfindung anhand von Figuren erläutert. An den Ausführungsbeispielen offenbar werdende Merkmale bilden jeweils einzeln und in jeder Merkmalskombination die Gegenstände der Ansprüche und auch die vorstehend erläuterten Ausgestaltungen vorteilhaft weiter. Es zeigen:
- Fig. 1: ein Fahrzeugaggregat mit einem Gehäuse, das eine Gehäusehüllstruktur und einen gasdurchlässigen Verschlusskörper eines ersten Ausführungsbeispiels aufweist,
- Fig. 2: einen Teilbereich des Fahrzeugaggregats mit der Gehäusehüllstruktur und nur teilweise dargestelltem Verschlusskörper und einer dadurch teilweise freigelegten Gehäuseöffnung in einer Isometrie,
- Fig. 3: den Verschlusskörper in einer Isometrie,
- Fig. 4: die teilweise freigelegte Gehäuseöffnung mit dem nur teilweise dargestelltem Verschlusskörper der Fig. 2 in einer Vergrößerung,
- Fig. 5: die Gehäusehüllstruktur im montierten Zustand in einem die Gehäuseöffnung und den Verschlusskörper enthaltenden Längsschnitt,
- Fig. 6: die Gehäusehüllstruktur vor der Montage des Verschlusskörpers in einer Draufsicht auf die noch offene Gehäuseöffnung,
- Fig. 7: ein Fahrzeugaggregat mit einer Gehäusehüllstruktur mit einer noch offenen Gehäuseöffnung eines zweiten Ausführungsbeispiels in einer Isometrie,
- Fig. 8: einen Teilbereich des Fahrzeugaggregats mit montierter Gehäusehüllstruktur und montiertem Verschlusskörper des zweiten Ausführungsbeispiels,
- Fig. 9: den Verschlusskörper des zweiten Ausführungsbeispiel in einer Schnitt-Isometrie,
- Fig. 10: einen Teilbereich des Fahrzeugaggregats mit der montierten Gehäusehüllstruktur des zweiten Ausführungsbeispiels in einer Schnitt-Isometrie,
- Fig. 11: eine Detaildarstellung der mit dem Verschlusskörper des zweiten Ausführungsbeispiels verschlossenen Gehäuseöffnung und eine Prüfsonde für eine Leckageprüfung,
- Fig. 12: die Darstellung der Figur 10 mit der angedockten Prüfsonde,
- Fig. 13: ein Fahrzeugaggregat mit einer montierten Gehäusehüllstruktur und einem montierten Verschlusskörper eines dritten Ausführungsbeispiels,
- Fig. 14: den Verschlusskörper des dritten Ausführungsbeispiels in einer Schnitt-Isometrie,
- Fig. 15: die Gehäusehüllstruktur und den Verschlusskörper des dritten Ausführungsbeispiels im montierten Zustand in einem Längsschnitt,
- Fig. 16: ein Fahrzeugaggregat mit einer montierten Gehäusehüllstruktur und einem montierten Verschlusskörper eines vierten Ausführungsbeispiels,
- Fig. 17: den Verschlusskörper des vierten Ausführungsbeispiels in einer Schnitt-Isometrie,
- Fig. 18: die Gehäusehüllstruktur des vierten Ausführungsbeispiels im montierten Zustand und einen modifizierten Verschlusskörper vor der Montage jeweils in einem Längsschnitt,
- Fig. 19: ein Fahrzeugaggregat mit einer Gehäusehüllstruktur eines fünften Ausführungsbeispiels und dem Verschlusskörper des ersten Ausführungsbeispiels in einem Längsschnitt, und
- Fig. 20: ein Fahrzeugaggregat mit einer montierten Gehäusehüllstruktur und einem Verschlusskörper eines sechsten Ausführungsbeispiels.

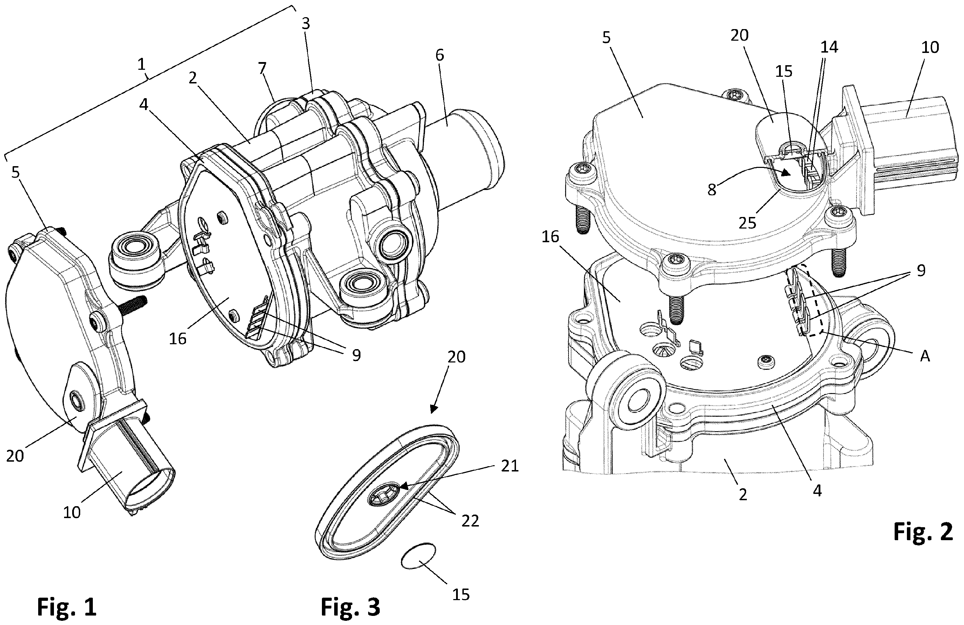

Figur 1 zeigt ein Fahrzeugaggregat in einer Isometrie. Bei dem Fahrzeugaggregat handelt es sich um ein sogenanntes Nebenaggregat, wie etwa eine Getriebeölpumpe, ein Gebläse, ein Verdichter oder insbesondere eine Kühlmittelpumpe. Das Fahrzeugaggregat weist ein Gehäuse 1 auf, in dem bewegliche und/oder unbewegliche Bauteile des Fahrzeugaggregats aufgenommen sind. Handelt es sich bei dem Fahrzeugaggregat um eines der beispielhaft genannten Nebenaggregate, etwa eine Kühlmittelpumpe, umfasst das Fahrzeugaggregat mechanische und elektrische Komponenten, wie etwa ein Förderrad zum Fördern eines Fluids, einen Elektromotor für den Drehantrieb des Förderrads und eine elektronische Steuerung für den Elektromotor, die gemeinsam in dem Gehäuse 1 aufgenommen sein können. Im Ausführungsbeispiel ist dies der Fall.

Das Gehäuse 1 umfasst ein Motorgehäuse 2, das einen Motorraum umgibt, in dem der Elektromotor aufgenommen ist, einen Pumpenraumdeckel 3, der an einer Stirnseite des Motorgehäuses 2 mit diesem gefügt ist und gemeinsam mit dem Motorgehäuse 2 einen Pumpenraum begrenzt, in dem das Förderrad der Pumpe angeordnet ist. Das Gehäuse 1 umfasst einen Einlass 6 und einen Auslass 7 für das zu fördernde Fluid, im Ausführungsbeispiel für ein Kühlmittel. Der Einlass 6 und der Auslass 7 sind strukturelle Bestandteile des Pumpenraumdeckels 3, der einschließlich des Einlasses 6 und des Auslasses 7 insbesondere in einem Stück geformt sein kann. Das Gehäuse 1 umfasst ferner einen Motorraumdeckel 4, der den Motorraum an der Stirnseite, die dem Pumpenraumdeckel 3 axial gegenüberliegt, begrenzt. Der Motorraumdeckel 4 dient als Träger für eine elektronische Steuerung für den Elektromotor. Die elektronische Steuerung selbst beziehungsweise deren Bauteile sind nicht dargestellt. Zu erkennen sind lediglich mehrere Bauteilkontakte 9 und eine Platine 16 zur Anordnung der elektronischen Bauteile der Steuerung. Die Bauteilkontakte 9 dienen dem elektrischen Anschluss des Elektromotors und der Steuerung. Sämtliche Bauteilkontakte 9 sind nah benachbart in einem gemeinsamen Konnektierungsbereich angeordnet und ragen im Konnektierungsbereich von der Platine 16 axial vor.

Das Gehäuse 1 umfasst ferner eine Gehäusehüllstruktur 5, die im Ausführungsbeispiel einen Elektronikraumdeckel bildet. In Figur 1 ist der Elektronikraumdeckel 5 beziehungsweise die Gehäusehüllstruktur 5 vom restlichen Gehäuse abgehoben, um den Blick auf die Platine 16 und die vorragenden Bauteilkontakte 9 freizugeben. Aus dem in Figur 1 dargestellten Zustand wird die Gehäusehüllstruktur 5 in axialer Richtung an den Motorraumdeckel 4 angelegt und mit diesem dicht gefügt, im Ausführungsbeispiel mittels einer umlaufenden Dichtung und einer Schraubverbindung. Im gefügten Zustand schließen der Motorraumdeckel 4 und die Gehäusehüllstruktur 5 den Elektronikraum flüssigkeitsdicht und weitestgehend auch gasdicht ein. Der Motorraumdeckel 4 trennt hierbei den Elektronikraum vom Motorraum.

Figur 2 zeigt den Gehäusebereich mit dem Motorraumdeckel 4 und der Gehäusehüllstruktur 5, die auch in Figur 2 im abgehobenen Zustand dargestellt ist. Zu erkennen sind wieder die Platine 16 und die Bauteilkontakte 9. Die Bauteilkontakte 9 sind im Konnektierungsbereich A angeordnet, der in Form einer Strichlinie angedeutet ist und von den Bauteilkontakten 9 und deren unmittelbaren Nahbereich gebildet wird.

Im fertigmontierten Zustand des Gehäuses 1 ist der Elektronikraum, wie bereits erwähnt, flüssigkeitsdicht und weitestgehend auch gasdicht verschlossen. Um Druckunterschiede zwischen dem Elektronikraum und der äußeren Umgebung des Gehäuses 1 dennoch ausgleichen zu können, weist die Gehäusehüllstruktur 5 eine lokale Gehäuseöffnung 8 auf, die im fertigmontierten Zustand durch einen Verschlusskörper 20 flüssigkeitsdicht, aber gasdurchlässig verschlossen wird. Die Figuren 1 und 2 zeigen die abgehobene Gehäusehüllstruktur 5 mit dem montierten Verschlusskörper 20, wobei der Verschlusskörper 20 in Figur 1 vollständig und in Figur 2 nur zu einer Hälfte dargestellt ist. In Figur 2 ist daher die nichtverschlossene Hälfte der Gehäuseöffnung 8 erkennbar.

Das Fahrzeugaggregat umfasst einen elektrischen Verbinder 10 für den Anschluss an ein elektrisches System eines Fahrzeugs. Der Verbinder 10 kann insbesondere ein elektrischer Steckverbinder sein, der mittels elektrisch leitender Steckverbindung an das elektrische System des Fahrzeugs anschließbar ist. Der Verbinder 10 ist ein struktureller Bestandteil der Gehäusehülle 5 und kann mit dieser in einem Stück geformt oder separat geformt und mit dem Deckelbereich der Gehäusehüllstruktur 5 fest und dicht gefügt sein.

In Figur 2 sind innere Verbinderkontakte 14 des Verbinders 10 durch die halboffene Gehäuseöffnung 8 erkennbar. Die inneren Verbinderkontakte 14 werden bei der Montage elektrisch leitend mit den Bauteilkontakten 9 gefügt. Der Konnektierungsbereich A umfasst im gefügten Zustand unmittelbar sowohl die Bauteilkontakte 9 als auch die inneren Verbinderkontakte 14.

Die Figuren 1 und 2 zeigen das fertigmontierte Gehäuse 1 mit der Gehäusehüllstruktur 5 in einem abgehobenen Zustand. Die Montagereihenfolge ist in Bezug auf die Montage der Gehäusehüllstruktur 5 und dem Verschlusskörper 20 jedoch so, dass die Gehäusehüllstruktur 5 mit dem Restgehäuse, im Ausführungsbeispiel unmittelbar mit dem Motorraumdeckel 4, bereits vor der Montage des Verschlusskörpers 20 gefügt wird. Der Verschlusskörper 20 wird an der Gehäusehüllstruktur 5 also erst angebracht, nachdem die Gehäusehüllstruktur 5 montiert ist und den Elektronikraum von der Gehäuseöffnung 8 abgesehen nach außen abschließt.

Figur 3 zeigt den Verschlusskörper 20 als solchen in einer isometrischen Sicht auf eine Unterseite, die im montierten Zustand dem Elektronikraum zugewandt ist. Der Verschlusskörper 20 umfasst einen gas- und dementsprechend auch flüssigkeitsdichten, flachen Trägerkörper mit einem Durchgang 21 und eine gasdurchlässige, aber flüssigkeitsdichte Druckausgleichsmembran 15, die in Figur 2 losgelöst vom Trägerkörper dargestellt ist. Im fertigen Verschlusskörper 20 ist die Druckausgleichsmembran 15 am Trägerkörper befestigt, so dass sie den Durchgang 21 abdeckt und um den Durchgang 21 umlaufend flüssigkeitsdicht mit dem Trägerkörper verbunden ist, beispielsweise mittels einer Klebe- oder Schweißverbindung.

Der Verschlusskörper 20, genauer gesagt dessen Trägerkörper, weist um den Durchgang 21 umlaufend eine Verschlusskörper-Dichtungsstruktur 22 zum flüssigkeitsdichten und weitestgehend auch gasdichten Fügen mit der Gehäusehüllstruktur 5 auf. Die Verschlusskörper-Dichtungsstruktur 22 umfasst an der Unterseite des Verschlusskörpers 20 um den Durchgang 21 jeweils umlaufend einen inneren und einen äußeren Steg, die ebenfalls um den Durchgang 21 umlaufend eine zur Unterseite hin offene Vertiefung zwischen sich begrenzen.

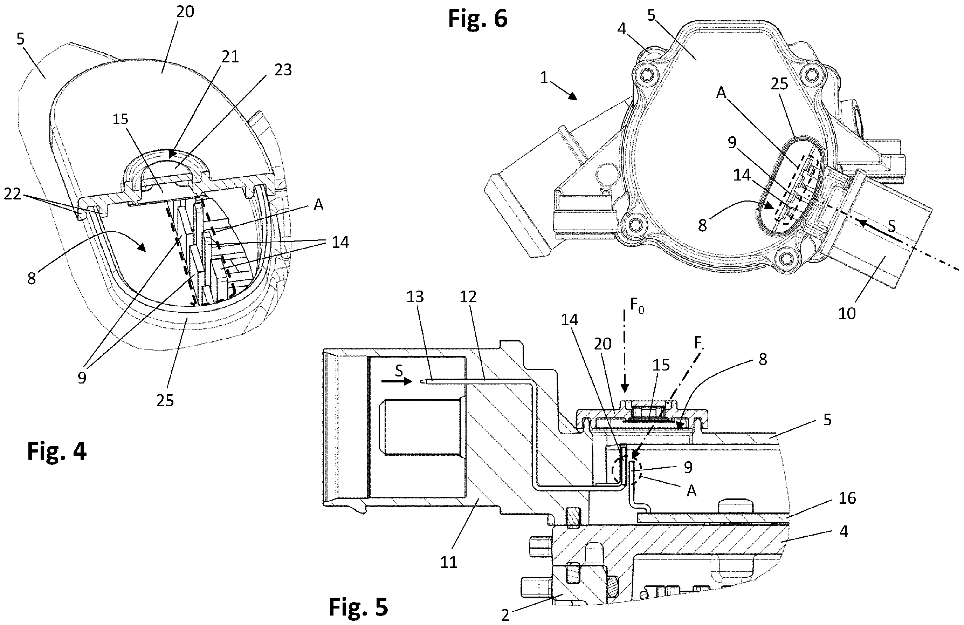

In Figur 4 sind wie in Figur 2 vom Verschlusskörper 20 nur eine Hälfte und dementsprechend die Gehäuseöffnung 8 teilweise offen und vergrößert dargestellt. Von der Gehäusehüllstruktur 5 sind nur ein unmittelbar an die Gehäuseöffnung 8 grenzender Wandbereich und eine Gehäuse-Dichtungsstruktur 25 erkennbar. Die Gehäusehüllstruktur 5 liegt am Restgehäuse an, so dass die Bauteilkontakte 9, anders als in Figur 3, ihren zugeordneten inneren Verbinderkontakten 14 unmittelbar gegenüberliegen. Die einander zugeordneten Bauteilkontakte 9 und Verbinderkontakte 14 können sich paarweise in einem kurzen Abstand gegenüberliegen oder unmittelbar in einem losen Druckkontakt aneinander liegen. Angedeutet ist auch wieder der Konnektierungsbereich A, der von den Bauteilkontakten 9 und Verbinderkontakten 14 gebildet wird und, sollte zwischen den einzelnen Kontaktpaaren 9 und 14, ein Zwischenraum verbleiben, auch diesen umfasst.

Die Gehäuse-Dichtungsstruktur 25 ragt vom angrenzenden Wandbereich der Gehäusehüllstruktur 5 stegartig auf und ragt im gefügten Zustand des Verschlusskörpers 20 in die Vertiefung der Dichtungsstruktur 22 des Verschlusskörpers 20 hinein. Die Gehäuse-Dichtungsstruktur 25 umrandet die Gehäuseöffnung 8. Der innere Steg und/oder der äu-ßere Steg der Verschlusskörper-Dichtungsstruktur 22 kann oder können im gefügten Zustand des Verschlusskörpers 20 an der Gehäuse-Dichtungsstruktur 25 innen und/oder außen anliegen. Der Verschlusskörper 20 ist im gefügten Zustand im Kontakt der Dichtungsstrukturen 22 und 25 um die Gehäuseöffnung 8 umlaufend dicht mit der Gehäusehüllstruktur 5 stoffschlüssig verbunden. Die Dichtungsstrukturen 22 und 25 sind in Doppelfunktion somit auch Fügestrukturen. Die stoffschlüssige Verbindung kann insbesondere eine Schweißverbindung, beispielsweise eine Laserschweißverbindung sein. Die Gehäusehüllstruktur 5 und der Verschlusskörper 20 sind zweckmäßigerweise aus Kunststoffmaterialien geformt, die unmittelbar miteinander schweißbar sind. Die Gehäusehüllstruktur 5 und der Verschlusskörper 20 bzw. dessen Trägerkörper können insbesondere aus dem gleichen Kunststoff geformt sein.

Die Dichtungsstrukturen 22 und 25 können geometrisch auch anders gestaltet sein. So können beispielsweise die Verschlusskörper-Dichtungsstruktur 22 mit nur einem Steg und die Gehäuse-Dichtungsstruktur 25 stattdessen, in Umkehrung der Verhältnisse, mit zwei Stegen und dazwischen einer Vertiefung versehen sein. Der Eingriff an sich bliebe gleich. Grundsätzlich können beide Dichtungsstrukturen 22 und 25 auch jeweils nur einen einzigen Steg zum dichten Fügen aufweisen.

Zum Verschlusskörper 20 ist noch nachzutragen, dass dessen Trägerkörper im Bereich des Durchgangs 21 einen Prallschutz 23 aufweist, der sich von außen gesehen vor der Druckausgleichsmembran 15 erstreckt, um diese vor eventuell zuströmenden Partikeln zu schützen.

Figur 5 zeigt die Gehäusehüllstruktur 5 im montierten Zustand, in dem die Gehäusehüllstruktur 5 und der axial gegenüberliegende Motorraumdeckel 4 den Elektronikraum mit der darin aufgenommenen elektronischen Steuerung begrenzen. Elektronische Bauteile der Steuerung sind nicht dargestellt. Dargestellt ist lediglich die Platine 16, auf der die elektronischen Bauteile der Steuerung angeordnet sind. Dargestellt ist auch einer der Bauteilkontakte 9, die von der Platine 16 nebeneinander jeweils in Richtung auf die Gehäuseöffnung 8 und den Verschlusskörper 20 vorragen.

Der Längsschnitt der Figur 5 erstreckt sich durch den Verbinder 10. Der Verbinder 10 umfasst ein Verbindergehäuse 11 und mehrere elektrische Verbindungsleitungen 12 jeweils mit einem äußeren Verbinderkontakt 13 und einem inneren Verbindungskontakt 14. Eine dieser Verbindungsleitungen 12 ist im Längsschnitt der Figur 5 erkennbar. Die Verbindungsleitungen 12 erstrecken sich im Verbindergehäuse 11 voneinander beabstandet. Sie sind elektrisch voneinander isoliert. Sie können insbesondere in eine Kunststoffmasse des Verbindergehäuses 11 eingegossen sein. Sie können aus flexiblen Drähten oder steiferen Schienen, Bändern oder aus anderen Ausgangsformen geformt sein. Die Verbindungsleitungen 12 erstrecken sich jeweils durch das Verbindergehäuse 11 und enden an einer äußeren Stirnseite des Verbinders 10 mit den äußeren Verbinderkontakten 13, um dort einen Verbinderanschluss zu bilden. Sie ragen mit ihren inneren Verbinderkontakten 14 in den Gehäuseinnenraum und enden dort im Konnektierungsbereich A. Die äußeren Verbinderkontakte 13 ragen zur Herstellung jeweils eines Stecckontakts parallel zueinander gegen eine Steckrichtung S frei und gerade nach außen vor. Alternativ könnten sie auch mit gemeinsamer Steckrichtung S muffenförmig sein und weibliche Verbinderkontakte bilden. Die Steckrichtung S weist normal bzw. ortogonal zur äußeren Stirnseite des Verbinders 10.

Die inneren Verbinderkontakte 14 ragen frei in den Elektronikraum (Gehäuseinnenraum) und dort jeweils in Richtung auf den zugehörigen Bauteilkontakt 9 vor. Dabei ragen die inneren Verbinderkontakte 14 wie bevorzugt, aber grundsätzlich nur beispielhaft, jeweils bis unter die Gehäuseöffung 8 vor. Der Konnektierungsbereich A liegt somit in einer orthogonalen Flucht F₀, die in Figur 5 durch einen strichlierten Pfeil angedeutet ist, unterhalb der Gehäuseöffnung 8 im Elektronikraum.

Der Verbinder 10 ragt von einer Umfangswand der Gehäusehüllstruktur 5 nach außen vor. Die Verbindungsleitungen 12 ragen mit ihren freien inneren Endabschnitten von der Umfangswand der Gehäusehüllstruktur 5 in den Elektronikraum in Richtung auf die zugehörigen Bauteilkontakte 9 vor. Die vorragenden Endabschnitte der Verbindungsleitungen 12 knicken unmittelbar bei den zugehörigen Bauteilkontakten 9 in Richtung auf die Gehäuseöffnung 8 ab, um über eine gewisse Länge mit den ebenfalls in Richtung auf die Gehäuseöffnung 8 vorragenden Bauteilkontakten 9 zu überlappen und zum Konnektieren einen Parallelstoß zu bilden.

In Figur 5 ist über die orthogonale Flucht F₀ hinaus auch noch eine schräge Flucht F dargestellt. Die beiden dargestellten Fluchten F und F₀ illustrieren, dass der Konnektierungsbereich A vor der Montage des Verschlusskörpers 20 über die zu diesem Zeitpunkt noch offene Gehäuseöffnung 8 auf geradem Wege zugänglich ist, beispielsweise mit einem Fügewerkzeug und/oder einem Prüfwerkzeug. Ebenso ist eine reine Sichtkontrolle durch die Gehäuseöffnung 8 möglich. Dabei kann das Werkzeug entsprechend der Flucht F₀ senkrecht oder der Flucht F entsprechend auch schräg durch die Gehäuseöffnung 8 zum Konnektierungsbereich A geführt werden. Vor der Montage des Verschlusskörpers 20 können mittels eines Fügewerkzeugs somit die zusammengehörigen Paare der Bauteilkontakte 9 und Verbinderkontakte 14 elektrisch leitend gefügt werden, beispielsweise jeweils mittels einer Schweißverbindung.

Die so erhaltene Zugänglichkeit zum Konnektierungsbereich kann nicht nur zum Fügen der Kontakte 9 und 14, sondern zusätzlich oder stattdessen auch zum Prüfen oder für eine Diagnose genutzt werden. So kann beispielsweise geprüft werden, ob die Kontakte ordnungsgemäß konnektiert sind. Über einen oder mehrere der Bauteilkontakte und grundsätzlich auch an jeder anderen Stelle, die außerhalb des Konnektierungsbereichs im Gehäuseinnenraum über die Gehäuseöffnung zugänglich ist, kann eine Diagnose eines damit verbundenen Elektrobauteils durchgeführt werden. So kann das Fahrzeugaggregat einen oder mehrere Sensoren, beispielsweise einen oder mehrere Hallsensoren zur Ermittlung der Drehzahl und/oder der Drehwinkelposition des Elektromotors, aufweisen. Für die Sensorik ist eine Möglichkeit zur Diagnose noch in der Montage des Fahrzeugaggregats und/oder später, beispielsweise im Falle einer Störung oder im Rahmen einer routinemäßigen Wartung, wünschenswert.

Figur 6 zeigt das Fahrzeugaggregat in einer zur Gehäuseöffnung 8 orthogonalen Draufsicht auf die Gehäusehüllstruktur 5. Die Gehäusehüllstruktur 5 ist flüssigkeitsdicht und weitestgehend auch gasdicht mit dem Restgehäuse, im Ausführungsbeispiel mit dem Motorraumdeckel 4, gefügt. Das Gehäuse 1 ist vom Verschlusskörper 20 abgesehen fertig montiert und kann über die Gehäuseöffnung 8 auf Dichtheit geprüft werden. Für die Prüfung wird der Innenraum des Gehäuses 1 über die Gehäuseöffnung 8 mit einem Überdruck und/oder einem Unterdruck zur Umgebung beaufschlagt. Wird festgestellt, dass das Gehäuse 1 ausreichend dicht ist, kann die Gehäuseöffnung 8 mit dem Verschlusskörper 20 verschlossen werden. Hierzu wird der Verschlusskörper 20 auf die Gehäusehüllstruktur 5 im Bereich der Gehäuseöffnung 8 aufgesetzt, so dass die Dichtungs- und Fügestrukturen 22 und 25 (Figur 4) ineinandergreifen und stoffschlüssig umlaufend dicht miteinander verbunden werden können.

In der Draufsicht der Figur 6 sind durch die noch offene Gehäuseöffnung 8 sämtliche Bauteilkontakte 9 und Verbinderkontakte 14 und somit der gesamte Konnektierungsbereich A sichtbar. Alle elektrisch leitend miteinander zu verbindenden Bauteilkontakte 9 und Verbinderkontakte 14 sind durch die Gehäuseöffnung 8 hindurch auf geradem Wege zugänglich. Die Konnektierung kann daher vorteilhafterweise nach der Montage der Gehäusehüllstruktur 5 vorgenommen werden. Mit der Montage der Gehäusehüllstruktur 5 sind zugleich auch die inneren Verbinderkontakte 14 relativ zu den zugehörigen Bauteilkontakten 9 im Konnektierungsbereich A positioniert, so dass die Kontakte 9 und 14 unmittelbar nach der Montage der Gehäusehüllstruktur 5 durch einen Fügeprozess elektrisch leitend verbunden (konnektiert) werden können. Die Dichtheitsprüfung wird zweckmäßigerweise nach der Konnektierung durchgeführt.

Die Bauteilkontakte 9 und der Verbinder 10 sind nahe beieinander angeordnet, so dass die inneren Verbinderkontakte 14 nur mit einer entsprechend kleinen Länge in den Gehäuseinnenraum vorragen müssen. Vorteilhafterweise mündet die Gehäuseöffnung 8 in die Hälfte des Gehäuseinnenraums, in die auch die Verbindungsleitungen 12 mit ihren Verbinderkontakten 14 vorragen. Die Bauteilkontakte 9 und dementsprechend der Konnektierungsbereich A können in Steckrichtung S unmittelbar hinter dem Verbinder 10 angeordnet sein. Die Gehäuseöffnung 8 kann vorteilhafterweise ebenfalls in Steckrichtung S unmittelbar hinter dem Verbinder 10 und in Draufsicht vorzugsweise in Überlappung mit dem Konnektierungsbereich A angeordnet sein.

Der Konnektierungsbereich A ist längs einer Verbindungslinie, die die Kontaktstellen der Bauteilkontakte 9 und Verbinderkontakte 14 verbindet, langgestreckt. Die Gehäuseöffnung 8 kann in Anpassung an die Abmessungen des Konnektierungsbereichs A geformt sein und längs der Verbindungslinie eine Länge aufweisen, die größer als die quer dazu gemessene Breite ist. So können der Konnektierungsbereich A und in Anpassung hierzu die Gehäuseöffnung 8 jeweils eine größte Erstreckung quer zur Steckrichtung S aufweisen.

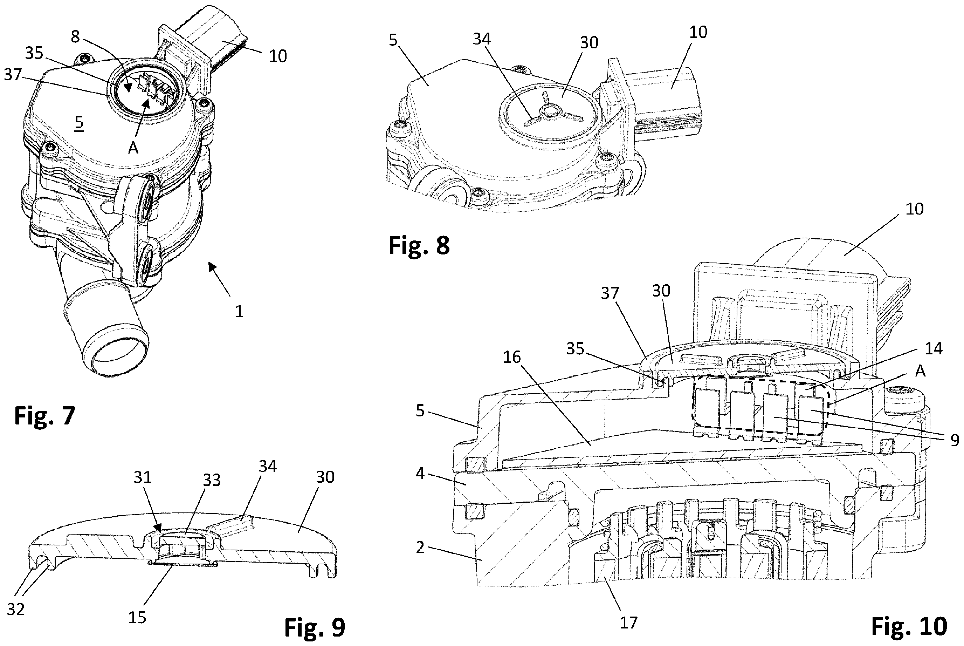

In einem in den Figuren 7 bis 12 dargestellten zweiten Ausführungsbeispiel weist das Fahrzeugaggregat ein Gehäuse 1 auf, das sich vom Gehäuse 1 des ersten Ausführungsbeispiels nur in Bezug auf die Gehäuseöffnung 8 und den entsprechend angepassten Verschlusskörper 30 unterscheidet. Im Übrigen entsprechen das Fahrzeugaggregat und insbesondere dessen Gehäuse 1 dem ersten Ausführungsbeispiel.

Im zweiten Ausführungsbeispiel ist die Gehäuseöffnung 8 in der Draufsicht kreisrund und wird von einer kreisrunden Gehäuse-Dichtungsstruktur 35 umrandet. Die Gehäuse-Dichtungsstruktur 35 ragt wie die Gehäuse-Dichtungsstruktur 25 des ersten Ausführungsbeispiels vom angrenzenden Wandbereich der Gehäusehüllstruktur 5 in Form eines kurzen Stegs auf, wie in der Gesamtisometrie des Figur 7 und der Schnitt-Isometrie der Figur 10 erkennbar ist.

Der Verschlusskörper 30 weist in Anpassung an die Gehäuse-Dichtungsstruktur 35 an seiner Unterseite eine ebenfalls kreisrunde Verschlusskörper-Dichtungsstruktur 32 auf, die wie im ersten Ausführungsbeispiel von zwei am Trägerkörper nach unten vorragenden Stegen und einer zwischen den Stegen verbleibenden Vertiefung gebildet wird. Die in der jeweiligen Draufsicht kreisrunde Form der Dichtungsstrukturen 32 und 35 ermöglicht es, den Verschlusskörper 30 durch Rotationsschweißen gasdicht mit der Gehäusehüllstruktur 5 zu fügen. Der Verschlusskörper 30 ist über seinen peripheren Rand zweckmäßigerweise ebenfalls kreisförmig, unbedingt erforderlich ist dies jedoch nicht.

Um das Rotationsschweißen zu erleichtern, ist der Verschlusskörper 30 an seiner im fertigmontierten Zustand des Gehäuses 1 nach außen weisenden Oberseite mehrere Fügehilfen 34 versehen, mit denen ein Fügewerkzeug zum Rotationsschweißen in einen Eingriff gebracht werden kann, um ein Drehmoment einzuleiten. Die Fügehilfen 34 sind als rippenförmige Vorsprünge gebildet. Der Verschlusskörper 30 entspricht im Übrigen dem Verschlusskörper 20 des ersten Ausführungsbeispiels und weist dementsprechend im zentralen Bereich einen Durchgang 31, das gasdurchlässige, aber flüssigkeitsdichte Druckausgleichselement 15 und in Zuströmrichtung vor dem Druckausgleichselement 15 einen Prallschutz 33 auf.

In der Schnitt-Isometrie der Figur 10 sind der Fügebereich des Motorgehäuses 2 und des Motorraumdeckels 4 und der Fügebereich des Motorraumdeckels 4 und der Gehäusehüllstruktur 5 erkennbar. Von dem im Motorraum aufgenommene Elektromotor ist ferner ein Stator 17 erkennbar, der bis nahe zum Motorraumdeckel 4 reicht. Figur 10 gibt den Blick in den Elektronikraum frei, der an einer inneren Stirnseite vom Motorraumdeckel 4 und an einer äußeren Stirnseite von der Gehäusehüllstruktur 5 begrenzt wird, die den Elektronikraum zusätzlich auch über den Umfang begrenzt.

Wie zum ersten Ausführungsbeispiel bereits erläutert, bestimmen die elektrisch leitend verbundenen Bauteilkontakte 9 und inneren Verbinderkontakte 14 den Konnektierungsbereich A. Der Konnektierungsbereich A ist wie im ersten Ausführungsbeispiel vollständig in einer zur Gehäuseöffnung 8 orthogonalen Flucht gelegen, wird in orthogonaler Draufsicht auf die Gehäuseöffnung 8 somit von dieser vollständig überlappt, so dass der Konnektierungsbereich A in dieser Draufsicht vollständig innerhalb des Umfangsrands der Gehäuseöffnung 8 liegt. Eine derartige Positionierung und Dimensionierung der Gehäuseöffnung 8 ermöglicht einen bestmöglichen, von der Umrandung der Gehäuseöffnung 8 abgesehen behinderungsfreien Zugang zum Konnektierungsbereich A.

Die Gehäusehüllstruktur 5 des zweiten Ausführungsbeispiels ist für ein einfaches Andocken eines Prüfwerkzeugs für eine Dichtheitsprüfung des Gehäuses 1 weitergebildet. Sie weist hierfür um die Gehäuse-Dichtungsstruktur 35 umlaufend einen Andockring 37 auf, der vergleichbar der Gehäuse-Dichtungsstruktur 35 vom angrenzenden Wandbereich der Gehäusehüllstruktur 5 nach außen vorragt. Im gefügten Zustand des Verschlusskörpers 30 umgibt der Andockring 37 auch den Verschlusskörper 30 und schließt mit einer planen äußeren Stirnfläche des Verschlusskörpers 30 bündig ab. Der Verschlusskörper 30 und der Andockring 37 bilden mit ihren freien Oberseiten zweckmäßigerweise gemeinsam eine Andockebene, an der ein Prüfwerkzeug besonders einfach mit Dichtkontakt andocken kann.

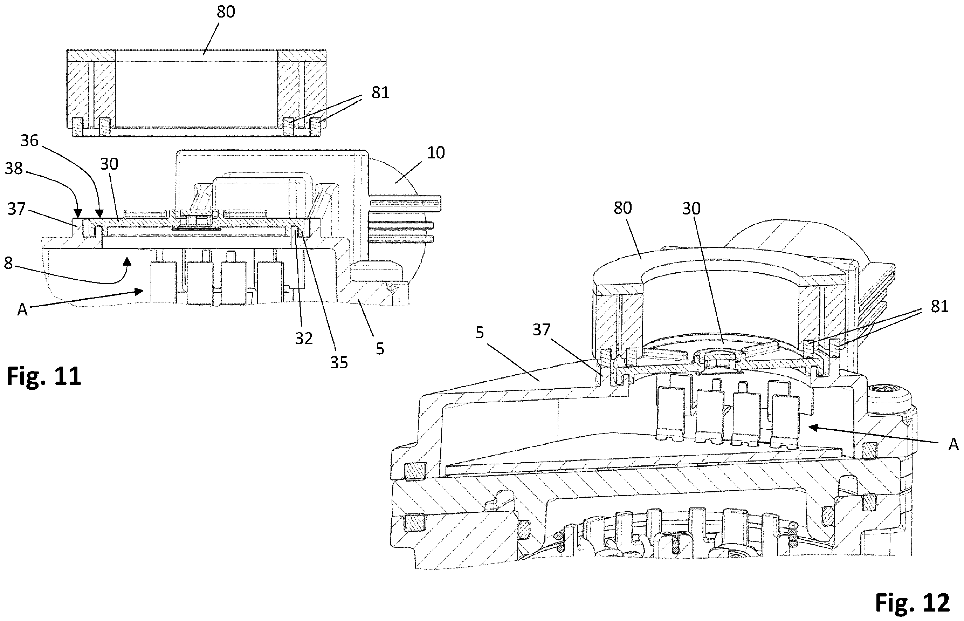

Figur 11 zeigt die Gehäusehüllstruktur 5 im Bereich der Gehäuseöffnung 8 und dem damit überlappenden Konnektierungsbereich A im Längsschnitt gemeinsam mit einer Prüfsonde 80 eines Prüfwerkzeugs für eine Dichtheitsprüfung. Der Verschlusskörper 30 ist montiert. Die Prüfsonde 80 ist für ein Andocken zur Dichtheitsprüfung der Fügeverbindung von Gehäusehüllstruktur 5 und Verschlusskörper 30 in einem kurzen axialen Abstand über dem Verschlusskörper 30 positioniert. Vor der Montage des

Verschlusskörpers 30 wurde mit der gleichen Prüfsonde 80 die Dichtheit des Gehäuses insgesamt überprüft, indem die Prüfsonde 80 bei noch offener Gehäuseöffnung 8 an den Andockring 37 angedockt und das Gehäuse über die Prüfsonde 80 mit einem Überdruck und/oder einem Unterdruck relativ zur Umgebung beaufschlagt wurde. Nach dieser Dichtheitshauptprüfung wurde der Verschlusskörper 30 montiert, so dass im nächsten Schritt eine nachgelagerte Dichtheitsprüfung der Fügeverbindung von Verschlusskörper 30 und Gehäusehüllstruktur 5 durchgeführt werden kann.

Die Prüfsonde 80 weist an ihrer der Gehäusehüllstruktur 5 zugewandten Unterseite zwei umlaufende Axialdichtungen 81 in Form eines inneren Dichtungsrings und eines den inneren Dichtungsring umgebenden äußeren Dichtungsrings auf. Für die Dichtheitsprüfung des Gehäuses bei noch offener Gehäuseöffnung 8 wird die Prüfsonde 80 mit ihrem äu-ßeren Dichtungsring 81 gegen eine zugewandte Andockfläche 38 des Andockrings 37 gedrückt, um mit der Andockfläche 38 die Gehäuseöffnung 8 umlaufend gasdicht abzuschließen. Die Andockfläche 38 ist eine freie obere Stirnfläche des Andockrings 37.

Figur 12 zeigt die Prüfsonde 80 im angedockten Zustand für eine abschließende zweite Dichtheitsprüfung, d.h. bei verschlossener Gehäuseöffnung 8. Für die zweite Dichtheitsprüfung wird die Prüfsonde 80 mit ihrem inneren Dichtungsring 81 gegen eine Andockfläche 36 des Verschlusskörpers 30 und dabei gleichzeitig mit ihrem äußeren Dichtungsring 81 wieder gegen die Andockfläche 38 des Andockrings 37 gedrückt. Anschließend wird ein zwischen dem Verschlusskörper 30 und dem Andockring 37 umlaufend verbleibender Ringspalt bei angedockter Prüfsonde 80 über diese mit einem Überdruck und/oder einem Unterdruck beaufschlagt. Somit wird über den freibleibenden Ringspalt die Dichtigkeit der Fügeverbindung von Gehäusehüllstruktur 5 und Verschlusskörper 30 geprüft. Die Andockfläche 36 des Verschlusskörpers 30 umgibt den Durchgang 31 und wird von der Andockfläche 38 des Andockrings 37 umgeben. Die beiden Andockflächen 36 und 38 bilden eine gemeinsame Andockebene, so dass eine geometrisch einfache, übliche Prüfsonde 80 verwendet werden kann.

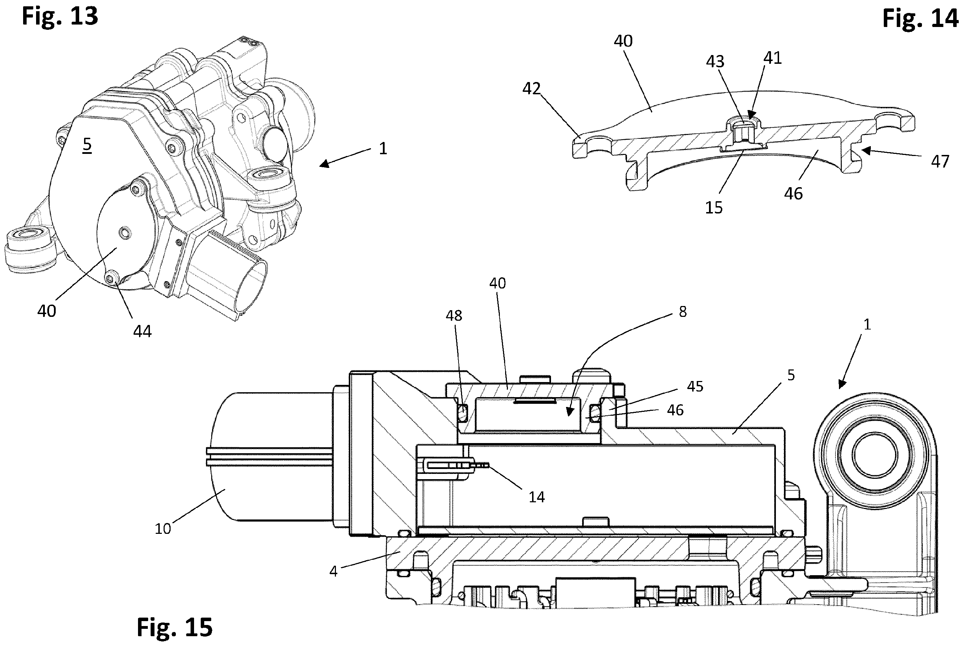

Die Figuren 13 bis 15 zeigen ein Fahrzeugaggregat mit einem Gehäuse 1, das eine Gehäusehüllstruktur 5 und einen Verschlusskörper 40 eines dritten Ausführungsbeispiels aufweist. Der Verschlusskörper 40 ist im Unterschied zu den Verschlusskörpern 20 und 30 mit der Gehäusehüllstruktur 5 nicht stoffschlüssig, sondern reibschlüssig mittels beispielsweise einer Schraubverbindung gefügt. In Figur 13 sind Befestigungselemente 44, beispielshaft in Form von Schraubbefestigungselementen erkennbar, wobei die Befestigung ebenfalls nur beispielhaft mit zwei Befestigungselementen 44 erfolgt. Der Verschlusskörper 40 wird mittels der Befestigungselemente 44 gegen die Gehäusehüllstruktur 5 gepresst.

In Figur 14 ist der Verschlusskörper 40 einzeln in einer Schnitt-Isometrie dargestellt. Der Verschlusskörper 40 entspricht in Bezug auf den Durchgang 41, die Druckausgleichsmembran 15 und den Prallschutz 43 den Verschlusskörpern des ersten und des zweiten Ausführungsbeispiels. Anstelle der Fügestrukturen 22 und 32, die zur Herstellung einer Schweißverbindungsnaht eingerichtet sind, kann der Verschlusskörper 40 als Fügestruktur 42 einen umlaufenden Flansch mit Durchgängen für die Befestigungselemente 44 oder, wie im Ausführungsbeispiel, mehrere Befestigungsflansche aufweisen, die von einem scheibenförmigen zentralen Bereich des Verschlusskörpers 40 nach außen flügelartig vorragen und jeweils von einem Durchgang für eines der Befestigungselemente 44 durchsetzt sind.

Vom scheibenförmigen Bereich des Verschlusskörpers 40 ragt an der Unterseite eine Dichtungsstruktur 46 in Form eines Stegs vor. Die Dichtungsstruktur 46 läuft zwischen dem Durchgang 41 und der Fügestruktur 42 um den Durchgang 41 um. Die Dichtungsstruktur 46 weist an ihrem äußeren Umfang umlaufend eine Aufnahme 47 für ein Dichtungselement auf. Die Aufnahme 47 ist als nutförmige Vertiefung am Außenumfang der Dichtungsstruktur 46 gebildet.

Figur 15 zeigt die Gehäusehüllstruktur 5 und den daran angrenzenden Bereich des Gehäuses 1 in einem Längsschnitt, der sich durch die Gehäuseöffnung 8 und den Verschlusskörper 40 erstreckt. Der Konnektierungsbereich befindet sich wie im ersten und den zweiten Ausführungsbeispiel in einer Flucht, vorzugsweise einer orthogonalen Flucht, mit der Gehäuseöffnung 8. Allerdings sind nur die inneren Verbinderkontakte14, aber nicht die Bauteilkontakte dargestellt.

Die Gehäusehüllstruktur 5 weist für ein gasdichtes Fügen mit dem Verschlusskörper 40 eine Gehäuse-Dichtungsstruktur 45 auf, die wie im ersten und im zweiten Ausführungsbeispiel die Gehäuseöffnung 8 umrandet und dort in Ausbildung eines Stegs von einem angrenzenden Wandbereich der Gehäusehüllstruktur 5 nach außen vorragt. Im gefügten Zustand ragt der Verschlusskörper 40 mit seiner Dichtungsstruktur 46 in die von der Gehäuse-Dichtungsstruktur 45 umrandete Gehäuseöffnung 8, so dass die Außenumfangsfläche der Versschlusskörper-Dichtungsstruktur 46 und eine Innenumfangsfläche der Gehäuse-Dichtungsstruktur 45 miteinander umlaufend einen Dichtpalt bilden. Der Dichtspalt wird von einem ringförmigen Dichtungselement 48 gasdicht abgedichtet. Das Dichtungselement 48 ist in der Aufnahme 47 (Figur 14) des Verschlusskörpers 40 aufgenommen. Das Dichtungselement 48 wirkt im Dichtspalt als Radialdichtung. Die Gehäuse-Dichtungsstruktur 45 ragt vom angrenzenden Wandbereich der Gehäusehüllstruktur 5 ausreichend weit vor, um den Dichtkontakt mit dem Dichtelement 48 umlaufend zu gewährleisten.

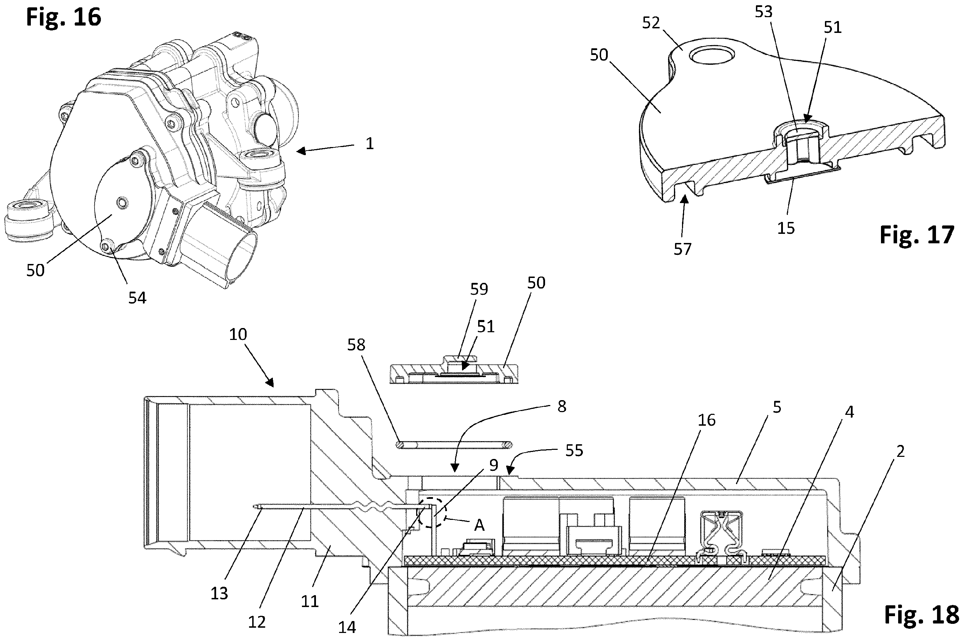

Die Figuren 16 bis 18 zeigen ein Fahrzeugaggregat mit einem Gehäuse 1, das eine Gehäusehüllstruktur 5 und einen Verschlusskörper 50 eines vierten Ausführungsbeispiels aufweist. Der Verschlusskörper 50 ist wie im dritten Ausführungsbeispiel reibschlüssig mit der Gehäusehüllstruktur 5 gefügt, beispielhaft wieder in Form einer Schraubverbindung mit mehreren Befestigungselementen 54. Hierfür weist der Verschlusskörper 50 eine Fügestruktur 52 auf, die als umlaufender Befestigungsflansch oder, wie im Ausführungsbeispiel, durch mehrere flügelartig vorragende Befestigungsflansche gebildet sein kann, wobei der jeweilige Befestigungsflansch von einem Durchgang für eines der Befestigungselemente 54 durchsetzt ist. Das jeweilige Befestigungselement 54 kann insbesondere wieder eine Befestigungsschraube sein. In Bezug auf die Befestigung an der Gehäusehüllstruktur 5 kann das vierte Ausführungsbeispiel dem dritten Ausführungsbeispiel entsprechen. Hinsichtlich des Durchgangs 51, der Durchausgleichsmembran 15 und des Prallschutzes 53 entspricht der in Figur 16 und im Detail in Figur 17 erkennbare Verschlusskörper 50 den Verschlusskörpern der vorherigen Ausführungsbeispiele.

Hinsichtlich der Abdichtung der Gehäuseöffnung 8 entspricht der Verschlusskörper 50 grundsätzlich dem dritten Ausführungsbeispiel, indem die Abdichtung mittels eines ringförmigen Dichtungselements 58 erfolgt (Figur 18). Der im Wesentlichen scheibenförmige Verschlusskörper 50 weist an seiner Unterseite einen vorragenden inneren Steg und einen vorragenden äußeren Steg auf, die zwischen dem zentralen Durchgang 51 und der Fügestruktur 52 um den Durchgang 51 umlaufen, wobei zwischen dem inneren und dem äußeren Steg umlaufend eine Vertiefung als Aufnahme für das Dichtungselement 58 gebildet ist. Die Stege bilden mit der Aufnahme die Dichtungsstruktur 57 des Verschlusskörpers 50. In einer Abwandlung kann die Dichtungsstruktur 57 auch als nutförmige Vertiefung unmittelbar in der Stirnfläche des Verschlusskörpers 50, ohne die erhaben vorragenden Stege, verwirklicht sein.

Das Dichtungselement 58 wird bei der Montage des Verschlusskörpers 50 gegen eine freie Stirnfläche der Gehäusehüllstruktur 5 gedrückt und dichtet dabei als Axialdichtung wirkend einen Dichtspalt zwischen der Gehäusehüllstruktur 5 und dem Verschlusskörper 50 um die Gehäuseöffnung 8 umlaufend gasdicht ab. Die Stirnfläche der Gehäusehüllstruktur 5, an der das Dichtungselement 58 im gefügten Zustand anliegt, kann zur Erleichterung der Bearbeitung freigestellt sein. Wie in Figur 18 erkennbar, weist die Gehäusehüllstruktur 5 hierfür eine Dichtungsstruktur 55 in Form einer flachen Abragung auf, die mit ihrer freien Stirnfläche die Anlagefläche für das Dichtungselement 58 bildet. Die Verwirklichung der Fügestruktur 55 als flache Abragung verbessert im Vergleich mit einer weiter nach außen vorragenden Gehäuseöffnung 8, wie sie etwa im dritten Ausführungsbeispiel vorliegt, die Zugänglichkeit zum Konnektierungsbereich A.

In Figur 18 ist ein Verschlusskörper 50 dargestellt, der hinsichtlich des Prallschutzes für die Druckausgleichsmembran 15 modifiziert ist. Anstelle des im Durchgang 51 in versenkter Position geformten Prallschutzes 53 der Figur 17 ragt ein modifizierter Prallschutz 59 an der Außenseite des Verschlusskörpers 50 nach außen vor. Er ist über eine Abkröpfung an einer Seite mit dem scheibenförmigen Bereich des Verschlusskörpers 50 verbunden, im Ausführungsbeispiel in einem Stück angeformt, und ragt ein kleines Stück über den scheibenförmigen Bereich nach außen vor, so dass über den überwiegenden Teil des Umfangs des Durchgangs 51 ein schmaler, durchströmbarer Spalt für den Druckausgleich verbleibt.

In Figur 18 ist angedeutet, dass die inneren Verbinderkontakte 14 einfach gerade in den Gehäuseinnenraum ragen und im Konnektierungsbereich A nur an ihren stirnseitigen Enden mit den Bauteilkontakten 9 gefügt und dadurch konnektiert werden können.

Von den erläuterten Unterschieden abgesehen entsprechen das dritte und das vierte Ausführungsbeispiel dem ersten Ausführungsbeispiel.

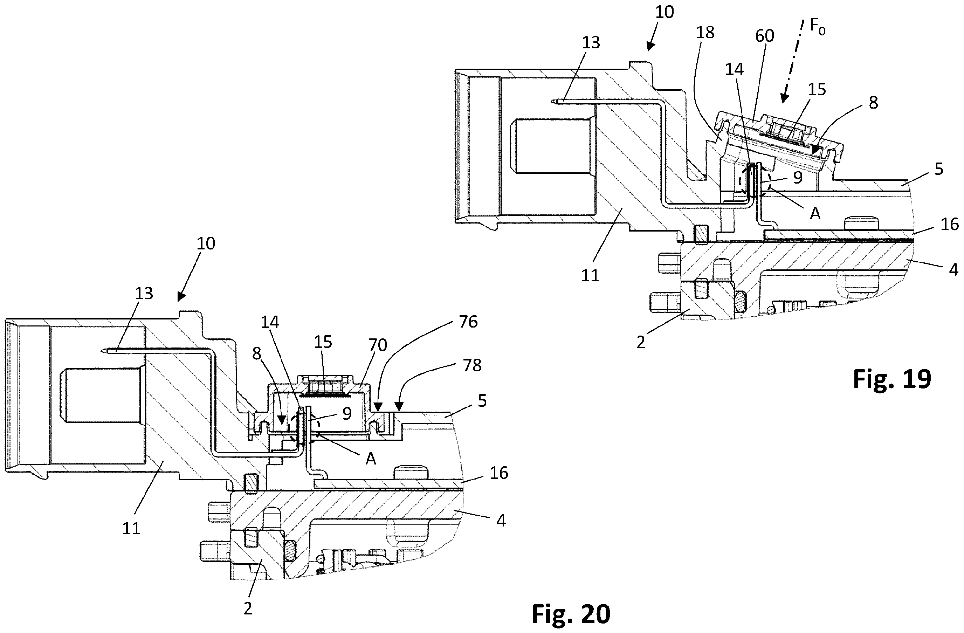

Figur 19 zeigt einen Ausschnitt eines Fahrzeugaggregats mit einer Gehäusehüllstruktur 5 eines fünften Ausführungsbeispiels. Das fünfte Ausführungsbeispiel unterscheidet sich vom ersten Ausführungsbeispiel in Bezug auf die Gehäuseöffnung 8 und die Anordnung der Bauteilkontakte 9 und Verbinderkontakte 14.

Im fünften Ausführungsbeispiel ist die Gehäuseöffnung 8 relativ zu dem stirnseitig gegenüberliegenden Motorraumdeckel 4 unter einem Neigungswinkel von vorzugsweise mindestens 10° und vorzugsweise höchstens 40° vom elektrischen Verbinder 10 wegweisend geneigt. Entsprechend geneigt ist die zur Gehäuseöffnung 8 orthogonale Flucht Fₒ. Für die Schrägstellung der Gehäuseöffnung 8 weist die Gehäusehüllstruktur 5 um die Gehäuseöffnung 8 umlaufend eine Umrandung 18 auf, die an ihrer dem Verbinder 10 nahen Seite weiter als an ihrer dem Verbinder 10 fernen Seite vorragt. Die so am vorderen Stirnende der Umrandung 18 erhaltene Gehäuseöffnung 8 entspricht dem Querschnitt nach dem ersten Ausführungsbeispiel. Die Umrandung 18 bildet mit ihrem vorderen bis zum Stirnende reichenden Abschnitt umlaufend eine Dichtungsstruktur, die der Gehäuse-Dichtungsstruktur 25 des ersten Ausführungsbeispiels entspricht und zugleich auch wieder die Funktion einer Fügestruktur erfüllt. Als Verschlusskörper 60 wird der Verschlusskörper des ersten Ausführungsbeispiels verwendet. Eine Schrägstellung der Gehäuseöffnung 8 kann für die Zugänglichkeit zum Konnektierungsbereich A insbesondere dann von Vorteil sein, wenn der elektrische Verbinder 10 nahe der Gehäuseöffnung 8 vorgesehen ist, wie dies bevorzugt wird, und über die Gehäuseöffnung 8 vorragt.

Die zweite Modifikation besteht darin, dass die Bauteilkontakte 9 und Verbinderkontakte 14 bis in die Umrandung 18 der Gehäuseöffnung 8 reichen und dadurch der Konnektierungsbereich A zumindest im Wesentlichen innerhalb der Umrandung 18 gebildet ist. Auch dies trägt zur Verbesserung der Zugänglichkeit des Konnektierungsbereichs A bei. Von den zwei beschriebenen Unterschieden abgesehen entspricht das fünfte Ausführungsbeispiel dem ersten Ausführungsbeispiel.

Figur 20 zeigt ein sechstes Ausführungsbeispiel, in dem ein Verschlusskörper 70 zum Einsatz kommt, der die Gehäuseöffnung 9 nicht nur abdeckelt, sondern zugleich auch einen größeren Teil des Konnektierungsbereichs A oder, wie im Ausführungsbeispiel, den gesamten Konnektierungsbereich A umgibt. Der Verschlusskörper 70 ist somit eine Verschlusskappe. Die Fügeverbindung mit der Gehäusehüllstruktur 5 einschließlich der damit auch erhaltenen Abdichtung entspricht dem ersten oder dem zweiten Ausführungsbeispiel, wie schon Figur 20 erkennen lässt.

Im sechsten Ausführungsbeispiel sind die Bauteilkontakte 9 und Verbinderkontakte 14 über die Gehäuseöffnung 8 hinaus nach außen verlängert und stehen an der äußeren Stirnseite der Gehäusehüllstruktur 5 sogar über die Gehäusehüllstruktur 5 geringfügig vor. Bei noch nicht verschlossener Gehäuseöffnung 8 ist der Konnektierungsbereich A daher besonders gut zugänglich. Der Konnektierungsbereich A liegt somit in einer Flucht, sogar einer orthogonalen Flucht, mit der Gehäuseöffnung 8, jetzt allerdings von außen gesehen vor der Gehäuseöffnung 8 und/oder in der Gehäuseöffnung 8, so dass ein Werkzeug zum Fügen oder Prüfen nicht durch die Öffnung in den Gehäuseinnenraum geführt werden muss.

Die Gehäuseöffnung 8 erstreckt sich in einem um den Konnektierungsbereich A abgesenkten Wandbereich der Gehäusehüllstruktur 5. Durch die Absenkung werden die Kontakte 9 und 14 und der Konnektierungsbereich A zumindest teilweise freigestellt. In Abwandlungen können auch nur die Kontakte 9 und 14 verlängert und auf eine Absenkung verzichtet werden. So können die Kontakte 9 und 14 in Abwandlungen der anderen Ausführungsbeispiele über die jeweilige Gehäuseöffnung 8 frei vorragen, wobei dann jeweils ein kappenförmiger Verschlusskörper vergleichbar dem Verschlusskörper 70 zum Einsatz käme, um die jeweilige Gehäuseöffnung 8 zu verschließen.

In Figur 20 ist auch erkennbar, dass die Gehäusehüllstruktur 5 und der Verschlusskörper 70 zum Andocken einer Prüfsonde für eine Dichtheitsprüfung aufeinander abgestimmt sind. Die Abstimmung besteht darin, dass der Verschlusskörper 70 an seiner Außenseite um seinen vom Druckausgleichselement 15 verschlossenen Durchgang umlaufend stirnseitig eine plane Andockfläche 76 und die Gehäusehüllstruktur 5 um die Andockfläche 76 umlaufend stirnseitig eine plane Andockfläche 78 aufweisen und die Andockflächen 76 und 78 über einen Ringspalt getrennt in einer gemeinsamen Andockebene erstreckt sind. Somit können eine erste Dichtheitsprüfung vor und eine zweite Dichtheitsprüfung nach dem Anbringen des Verschlusskörpers 70 wie zum zweiten Ausführungsbeispiel erläutert mit der Prüfsonde 80 (Figuren 11 und 12) durchgeführt werden.

### Bezugszeichen:

- 1: Gehäuse
- 2: Motorgehäuse, Gehäuseträgerstruktur
- 3: Pumpenraumdeckel
- 4: Motorraumdeckel, Gehäuseträgerstruktur
- 5: Gehäusehüllstruktur, Elektronikraumdeckel
- 6: Einlass
- 7: Auslass
- 8: Gehäuseöffnung
- 9: Bauteilkontakt
- 10: Verbinder
- 11: Verbindergehäuse
- 12: Verbindungsleitung
- 13: äußerer Verbinderkontakt
- 14: innerer Verbinderkontakt
- 15: Druckausgleichselement
- 16: Elektrobauteil, Steuerung
- 17: Elektrobauteil, Stator
- 18: Umrandung
- 19: -
- 20: Verschlusskörper
- 21: Durchgang
- 22: Dichtungsstruktur, Fügestruktur
- 23: Prallschutz
- 24: -
- 25: Dichtungsstruktur, Fügestruktur
- 26: -
- 27: -
- 28: -
- 29: -
- 30: Verschlusskörper
- 31: Durchgang
- 32: Dichtungsstruktur, Fügestruktur
- 33: Prallschutz
- 34: Fügehilfe
- 35: Dichtungsstruktur, Fügestruktur
- 36: Andockfläche
- 37: Andockring
- 38: Andockfläche
- 39: -
- 40: Verschlusskörper
- 41: Durchgang
- 42: Fügestruktur
- 43: Prallschutz
- 44: Befestigungselement
- 45: Dichtungsstruktur
- 46: Dichtungsstruktur, Steg
- 47: Dichtungsstruktur, Aufnahme
- 48: Dichtungselement
- 49: -
- 50: Verschlusskörper
- 51: Durchgang
- 52: Fügestruktur
- 53: Prallschutz
- 54: Befestigungselement
- 55: Dichtungsstruktur, Fügestruktur
- 56: -
- 57: Dichtungsstruktur, Vertiefung
- 58: Dichtungselement
- 59: Prallschutz
- 60: Verschlusskörper
- 70: Verschlusskörper
- 76: Andockfläche
- 78: Andockfläche
- 80: Prüfsonde
- 81: Dichtung

- A: Konnektierungsbereich
- F: Flucht
- F₀: orthogonale Flucht

## Patentansprüche

1. Fahrzeugaggregat umfassend:
1.1 ein Gehäuse (1) mit einer Gehäusehüllstruktur (5), die einen Innenraum des Gehäuses (1) am Umfang und/oder an einer Stirnseite begrenzt und eine Gehäuseöffnung (8) aufweist,
1.2 ein im Gehäuse (1) aufgenommenes Elektrobauteil (16, 17),
1.3 einen elektrischen Verbinder (10) mit einem elektrisch leitenden äußeren Verbinderkontakt (13) für den elektrischen Anschluss des Fahrzeugaggregats an ein elektrisches System eines Fahrzeugs und einem elektrisch leitenden inneren Verbinderkontakt (14),
1.4 einen mit dem Elektrobauteil (16) elektrisch leitend verbundenen Bauteilkontakt (9), der in einem Konnektierungsbereich (A) mit dem inneren Verbinderkontakt (14) elektrisch leitend gefügt ist,
1.5 einen Verschlusskörper (20; 30; 40; 50; 60; 70) zum Verschließen der Gehäuseöffnung (8) gegen Flüssigkeitseintritt und
1.6 ein gasdurchlässiges Druckausgleichselement (15), das Bestandteil des Verschlusskörpers (20; 30; 40; 50; 60; 70) ist, um über den Verschlusskörper einen Druckausgleich mit der Umgebung des Gehäuses (1) zu ermöglichen,
1.7 wobei die Gehäuseöffnung (8) im nicht verschlossenen Zustand einen Zugriff auf den Konnektierungsbereich (A) mit einem Werkzeug und/oder eine Sichtkontrolle des Konnektierungsbereichs (A) ermöglicht.

2. Fahrzeugaggregat nach dem vorhergehenden Anspruch, wobei die Gehäuseöffnung (8) in einer Flucht (F, Fₒ) mit dem Konnektierungsbereich (A) liegt und im nicht verschlossenen Zustand den Zugriff auf den Konnektierungsbereich (A) mit dem Werkzeug und/oder die Sichtkontrolle des Konnektierungsbereichs (A) auf geradem Wege ermöglicht.

3. Fahrzeugaggregat nach einem der vorhergehenden Ansprüche, wobei die Gehäuseöffnung (8) in Draufsicht mit einem flächenmäßig zumindest überwiegenden Teil des Konnektierungsbereichs (A), vorzugsweise dem Bauteilkontakt (9) und/oder dem inneren Verbinderkontakt (14), überlappt.

4. Fahrzeugaggregat nach einem der vorhergehenden Ansprüche, wobei das Gehäuse (1) eine Gehäuseträgerstruktur (2, 4), die den Elektromotor und/oder die elektronische Steuerung (16) lagert, und einen mit der Gehäuseträgerstruktur (2, 4) gefügten Gehäusedeckel (5) umfasst, die Gehäuseträgerstruktur (2, 4) und der Gehäusedeckel (5) gemeinsam einen Gehäuseinnenraum umgeben, in dem das jeweilige Elektrobauteil (16) aufgenommen und/oder der Konnektierungsbereich (A) gelegen ist oder sind, und wobei der Gehäusedeckel (5) die Hüllstruktur mit der Gehäuseöffnung (8) ist.

5. Fahrzeugaggregat nach einem der vorhergehenden Ansprüche, wobei die Gehäusehüllstruktur (5) und der elektrische Verbinder (10) eine Montageeinheit bilden und der elektrische Verbinder (10) ein Verbindergehäuse (11) und eine durch das Verbindergehäuse (11) in den Innenraum des Gehäuses (1) erstreckte elektrische Verbindungsleitung (12) umfasst, die den äußeren Verbinderkontakt (13) und den inneren Verbinderkontakt (14) bildet, wobei das Verbindergehäuse (11) die Verbindungsleitung (12) hält und relativ zur Gehäuseöffnung (8) positioniert, vorzugsweise so, dass der innere Verbinderkontakt (14) in einer durch die Gehäuseöffnung (8) erstreckten Flucht (F, F₀) liegt.

6. Fahrzeugaggregat nach einem der vorhergehenden Ansprüche, wobei
- das Fahrzeugaggregat an einer Stirnseite des elektrischen Verbinders (10) an das elektrische System des Fahrzeugs anschließbar ist,
- eine bezüglich des Verbinders (10) zentrale, orthogonal zur Stirnseite des Verbinders (10) erstreckte Achse (S) die Gehäuseöffnung (8) in Draufsicht auf die Gehäuseöffnung (8) schneidet,
- und die Gehäuseöffnung (8) dem Verbinder (10) nahe in der Draufsicht auf die Gehäuseöffnung (8) in einer Hälfte der Gehäusehüllstruktur (5) angeordnet ist, in die der innere Verbinderkontakt (14) vorragt.

7. Fahrzeugaggregat nach einem der vorhergehenden Ansprüche, wobei der Verschlusskörper (20; 30; 40; 50; 60; 70) einen Durchgang (21; 31; 41; 51), den das Druckausgleichselement (15) flüssigkeitsdicht verschließt, und eine den Durchgang (21; 31; 41; 51) umgebende Dichtungsstruktur (22; 32; 46, 47; 56, 57) für eine in Draufsicht um die Gehäuseöffnung (8) oder in der Gehäuseöffnung (8) umlaufend flüssigkeitsdichte, vorzugsweise gasdichte Abdichtung der Gehäuseöffnung (8) umfasst.

8. Fahrzeugaggregat nach einem der vorhergehenden Ansprüche, wobei der Verschlusskörper (20; 30; 60; 70) längs einer Fügefläche oder -linie (25; 35) um die Gehäuseöffnung (8) umlaufend mit dem Gehäuse (1) flüssigkeitsdicht, vorzugsweise gasdicht, stoffschlüssig gefügt ist, vorzugsweise durch Schweißen, oder wobei der Verschlusskörper (40; 50) mittels einer Schraub- oder Rastverbindung (42, 44; 52, 54) und einem Dichtungselement (48; 58) mit dem Gehäuse (1) flüssigkeitsdicht, vorzugsweise gasdicht, gefügt ist.

9. Fahrzeugaggregat nach einem der vorhergehenden Ansprüche, wobei der Verschlusskörper (30; 70) um die Gehäuseöffnung (8) umlaufend mit dem Gehäuse (1) gasdicht gefügt ist und wobei das Gehäuse (1) in Draufsicht um den Verschlusskörper (30; 70) umlaufend eine freie Andockfläche (38; 78) für einen umlaufend gasdichten Kontakt mit einer Prüfsonde (80) zur Bestimmung der Dichtheit des Gehäuses (1) und/oder der Fügeverbindung von Verschlusskörper (30; 70) und Gehäuse (1) mittels Überdruck- und/oder Unterdruck-Leckageprüfung aufweist.

10. Fahrzeugaggregat nach dem vorhergehenden Anspruch, wobei der Verschlusskörper (20; 70) einen Durchgang (31), den das Druckausgleichselement (15) flüssigkeitsdicht verschließt, und um den Durchgang (31) umlaufend eine freie Andockfläche (36; 76) für einen umlaufend gasdichten Kontakt mit der Prüfsonde (80) aufweist.

11. Fahrzeugaggregat nach dem vorhergehenden Anspruch, wobei die Andockflächen (36, 38; 76, 78) plane, parallele Stirnflächen, sind, die sich vorzugsweise in einer gemeinsamen Andockebene erstrecken.

12. Fahrzeugaggregat nach einem der vorhergehenden Ansprüche, wobei das Fahrzeugaggregat eine Pumpe-Motor-Einheit ist und in dem Gehäuse (1) ein Förderrad zum Fördern von Fluid, ein Elektromotor (17) für einen Drehantrieb des Förderrads und eine elektronische Steuerung (16) für den Elektromotor (17) angeordnet sind.

13. Verfahren zur Montage eines Fahrzeugaggregats, vorzugsweise des Fahrzeugaggregats nach einem der vorhergehenden Ansprüche, das Fahrzeugaggregat umfassend:
13.1 ein Gehäuse (1) mit einer Hüllstruktur (5), die einen Innenraum des Gehäuses (1) am Umfang und/oder an einer Stirnseite begrenzt und eine Gehäuseöffnung (8) aufweist,
13.2 ein im Gehäuse (1) aufgenommenes Elektrobauteil (16, 17), beispielsweise ein Elektromotor (17) oder eine elektronische Steuerung (16),
13.3 einen elektrischen Verbinder (10) mit einem äußeren Verbinderkontakt (13) für den elektrischen Anschluss des Fahrzeugaggregats an ein elektrisches System eines Fahrzeugs und einem inneren Verbinderkontakt (14),
13.4 einen mit dem Elektrobauteil (16, 17) elektrisch leitend verbundenen Bauteikontakt (9), der in einem Konnektierungsbereich (A) dem inneren Verbinderkontakt (14) benachbart ist,
13.5 einen Verschlusskörper (20; 30; 40; 50; 60; 70) zum Verschließen der Gehäuseöffnung (8) gegen Flüssigkeitseintritt und
13.6 ein gasdurchlässiges Druckausgleichselement (15), das Bestandteil des Verschlusskörpers (20; 30; 40; 50; 60; 70) ist, um über den Verschlusskörper einen Druckausgleich mit der Umgebung des Gehäuses (1) zu ermöglichen,
13.7 wobei vor Verschließen der Gehäuseöffnung (8) der innere Verbinderkontakt (14) mittels eines Fügewerkzeugs elektrisch leitend mit dem Bauteilkontakt (9) gefügt wird,
13.8 und wobei die Gehäuseöffnung (8) mit dem Verschlusskörper (20; 30; 40; 50) flüssigkeitsdicht, aber gasdurchlässig verschlossen wird.

14. Verfahren nach dem vorhergehenden Anspruch, bei dem
- der Konnektierungsbereich (A) im Innenraum des Gehäuses (1) gebildet ist und das Fügewerkzeug durch die noch offene Gehäuseöffnung (8) zum Konnektierungsbereich (A) geführt und die Kontakte (9, 14) elektrisch leitend gefügt werden, oder bei dem
- der Bauteilkontakt (9) und der innere Verbinderkontakt (14) durch die Gehäuseöffnung (8) nach außen vorragen und im Konnektierungsbereich (A) außen vor der Gehäuseöffnung (8) elektrisch leitend gefügt werden und zum Verschließen der Gehäuseöffnung (8) ein kappenförmiger Verschlusskörper (70) verwendet wird.

15. Verfahren nach einem der zwei unmittelbar vorhergehenden Ansprüche, bei dem die Gehäusehüllstruktur (5) mit dem Verbinder (10) eine Montageeinheit bildet und mit einer Gehäuseträgerstruktur (2, 4), die das Elektrobauteil (16, 17) lagert, gefügt wird und der innere Verbinderkontakt (14) durch das Fügen der Gehäusehüllstruktur (5) im Konnektierungsbereich (A) für das elektrisch leitende Fügen positioniert ist.
